# EUROPEAN PATENT APPLICATION

(11) **EP 4 697 742 A1**
(43) Date of publication of application: **18.02.2026**
(21) Application number: 25714264.6
(22) Date of filing: 25.03.2025
(51) Int. Cl.: H04R 1/00, H04R 29/00

(54) **ELECTRONIC DEVICE, METHOD, AND NON-TRANSITORY COMPUTER-READABLE RECORDING MEDIUM FOR OUTPUTTING AUDIO SIGNALS THROUGH DIFFERENT TYPES OF AUDIO CIRCUITS**

(30) Priority: 03.07.2024 KR 20240087856; 06.08.2024 KR 20240104965
(71) Applicant: Samsung Electronics Co., Ltd., Suwon-si, Gyeonggi-do 16677 (KR)
(72) Inventor: CHOI, Injune, Suwon-si, Gyeonggi-do 16677 (KR); KIM, Kyumin, Suwon-si, Gyeonggi-do 16677 (KR); KIM, Uk, Suwon-si, Gyeonggi-do 16677 (KR); LEE, Hyojin, Suwon-si, Gyeonggi-do 16677 (KR)
(74) Representative: Appleyard Lees IP LLP
(86) International application number: PCT/KR2025/095094
(87) International publication number: WO 2026/010472

(57) **Abstract**

An electronic device is disclosed. The electronic device obtains, from a first audio output IC via an audio interface, sensing data identified by IV sensing circuitry in the first audio output IC, in relation to output of an audio via the first speaker. The electronic device adjusts a first audio signal on a first channel, based on applying the sensing data to a source audio. The electronic device provides, to each of a first audio output IC and a second audio output IC via the audio interface, an audio signal including the adjusted first audio signal on the first channel and a second audio signal on a second channel.

## Description

### [Technical Field]

The following descriptions relate to an electronic device, a method, and a non-transitory computer readable storage medium for outputting an audio signal via heterogeneous audio circuits.

### [Background Art]

A multimedia device such as a smartphone, a smart pad, and a smart watch may play audio data. The audio data may be radiated to the outside through a speaker. The multimedia device may include a plurality of speakers, and may include a plurality of amplifiers for the plurality of speakers. The plurality of amplifiers may convert a digital signal into an analog signal, amplify it, and output the amplified analog signal through the speaker. Such a multimedia device may include heterogeneous amplifiers having different performance and/or configurations.

### [Disclosure]

### [Technical Solution]

An electronic device is disclosed. The electronic device may comprise a first audio output integrated circuit (IC) including IV (current and voltage) sensing circuitry, a first speaker connected to the first audio output IC, a second audio output IC, a second speaker connected to the second audio output IC, processing circuitry including an audio interface connected to each of the first audio output IC and the second audio output IC, and memory, comprising one or more storage mediums, storing instructions. The instructions may be configured to, when executed by the processing circuitry individually or collectively, cause the electronic device to obtain, from the first audio output IC via the audio interface, sensing data identified by the IV sensing circuitry in the first audio output IC, in relation to output of an audio via the first speaker. The instructions may be configured to, when executed by the processing circuitry individually or collectively, cause the electronic device to adjust a first audio signal on a first channel, based on applying the sensing data to source audio. The instructions may be configured to, when executed by the processing circuitry individually or collectively, cause the electronic device to provide, to each of the first audio output IC and the second audio output IC via the audio interface, an audio signal including the adjusted first audio signal on the first channel and a second audio signal on a second channel. The applying the sensing data to the source audio may comprise applying the sensing data to the first audio signal on the first channel among the first audio signal on the first channel and a second audio signal on the second channel included in the source audio.

An electronic device is disclosed. The electronic device may comprise a first amplifier IC that includes IV (current and voltage) sensing circuitry identifying voltage and/or a current of a first audio signal outputted through the first amplifier integrated circuitry (IC), a first speaker, connected to the first amplifier IC, converting the first audio signal into sound, a second amplifier IC outputting a second audio signal, a second speaker, connected to the second amplifier IC, converting the second audio signal into sound, processing circuitry, including an audio interface electrically connected to the first amplifier IC and the second amplifier IC, generating an audio signal to be inputted to the first amplifier IC and the second amplifier IC through the audio interface, and memory, storing instructions, comprising one or more storage mediums. The instructions may be configured to, when executed by the processing circuitry individually or collectively, cause the electronic device to identify source audio. The instructions may be configured to, when executed by the processing circuitry individually or collectively, cause the electronic device to determine a speaker to which the source audio is to be outputted. The instructions may be configured to, when executed by the processing circuitry individually or collectively, cause the electronic device to, based on that the source audio is determined to be outputted via the first speaker and the second speaker, based on a sensing value identified via the IV sensing circuitry, adjust an output level of a portion of the source audio. The instructions may be configured to, when executed by the processing circuitry individually or collectively, cause the electronic device to, based on that the source audio is determined to be outputted via the first speaker and the second speaker, transfer the source audio in which the output level of the portion is adjusted, to the first amplifier IC and the second amplifier IC via the audio interface. The instructions may be configured to, when executed by the processing circuitry individually or collectively, cause the electronic device to, based on that the source audio is determined to be outputted via the first speaker and the second speaker, control the first amplifier IC, such that the first amplifier IC outputs the first audio signal corresponding to the portion in which the output level of the source audio is adjusted, via the first speaker. The instructions may be configured to, when executed by the processing circuitry individually or collectively, cause the electronic device to, based on that the source audio is determined to be outputted via the first speaker and the second speaker, control the second amplifier IC, such that the second amplifier IC outputs the second audio signal corresponding to another portion in which the output level of the source audio is not adjusted, via the second speaker.

A method is disclosed. The method may be performed by an electronic device comprising a first audio output integrated circuit (IC) including IV (current and voltage) sensing circuitry, a first speaker connected to the first audio output IC, a second audio output IC, a second speaker connected to the second audio output IC, and processing circuitry including an audio interface connected to each of the first audio output IC and the second audio output IC. The method may comprise obtaining, from the first audio output IC via the audio interface, sensing data identified by the IV sensing circuitry in the first audio output IC, in relation to output of an audio via the first speaker. The method may comprise adjusting a first audio signal on a first channel, based on applying the sensing data to source audio. The method may comprise providing, to each of the first audio output IC and the second audio output IC via the audio interface, an audio signal including the adjusted first audio signal on the first channel and a second audio signal on a second channel. The applying the sensing data to the source audio may comprise applying the sensing data to the first audio signal on the first channel among the first audio signal on the first channel and a second audio signal on the second channel included in the source audio.

A method is disclosed. The method may be performed by an electronic device comprising a first amplifier IC including IV (current and voltage) sensing circuitry identifying voltage and/or a current of a first audio signal outputted through the first amplifier integrated circuitry (IC), a first speaker, connected to the first amplifier IC, converting the first audio signal into sound, a second amplifier IC outputting a second audio signal, a second speaker, connected to the second amplifier IC, converting the second audio signal into sound, and processing circuitry, including an audio interface electrically connected to the first amplifier IC and the second amplifier IC, generating an audio signal to be inputted to the first amplifier IC and the second amplifier IC via the audio interface. The method may comprise identifying source audio. The method may comprise determining a speaker to which the source audio is to be outputted. The method may comprise, based on that the source audio is determined to be outputted via the first speaker and the second speaker, based on a sensing value identified via the IV sensing circuitry, adjusting an output level of a portion of the source audio. The method may comprise, based on that the source audio is determined to be outputted via the first speaker and the second speaker, transferring the source audio in which the output level of the portion is adjusted, to the first amplifier IC and the second amplifier IC via the audio interface. The method may comprise, based on that the source audio is determined to be outputted via the first speaker and the second speaker, controlling the first amplifier IC, such that the first amplifier IC outputs the first audio signal corresponding to the portion in which the output level of the source audio is adjusted, via the first speaker. The method may comprise, based on that the source audio is determined to be outputted via the first speaker and the second speaker, controlling the second amplifier IC, such that the second amplifier IC outputs the second audio signal corresponding to another portion in which the output level of the source audio is not adjusted, via the second speaker.

A non-transitory computer readable storage medium is disclosed. The non-transitory computer readable storage medium may comprise one or more programs including instructions. The instructions may be configured, when executed by processing circuitry of an electronic device comprising a first audio output integrated circuit (IC) including IV (current and voltage) sensing circuitry, a first speaker connected to the first audio output IC, a second audio output IC, a second speaker connected to the second audio output IC, and the processing circuitry including an audio interface connected to each of the first audio output IC and the second audio output IC, individually or collectively, to cause the electronic device to obtain, from the first audio output IC via the audio interface, sensing data identified by the IV sensing circuitry in the first audio output IC, in relation to output of an audio via the first speaker. The instructions may be configured, when executed by the processing circuitry individually or collectively, to cause the electronic device to adjust a first audio signal on a first channel, based on applying the sensing data to source audio. The instructions may be configured, when executed by the processing circuitry individually or collectively, to cause the electronic device to provide, to each of the first audio output IC and the second audio output IC via the audio interface, an audio signal including the adjusted first audio signal on the first channel and a second audio signal on a second channel. The applying the sensing data to the source audio may comprise applying the sensing data to the first audio signal on the first channel between the first audio signal on the first channel and a second audio signal on the second channel included in the source audio.

A non-transitory computer readable storage medium is disclosed. The non-transitory computer readable storage medium may comprise one or more programs including instructions. The instructions may be configured to, when executed by the processing circuitry individually or collectively, cause the electronic device comprising a first amplifier IC including IV (current and voltage) sensing circuitry identifying voltage and/or a current of a first audio signal outputted through the first amplifier integrated circuitry (IC), a first speaker, connected to the first amplifier IC, converting the first audio signal into sound, a second amplifier IC outputting a second audio signal, a second speaker, connected to the second amplifier IC, converting the second audio signal into sound, and processing circuitry, including an audio interface electrically connected to the first amplifier IC and the second amplifier IC, generating an audio signal to be inputted to the first amplifier IC and the second amplifier IC via the audio interface, to identify source audio. The instructions may be configured to, when executed by the processing circuitry individually or collectively, cause the electronic device to determine a speaker to which the source audio is to be outputted. The instructions may be configured to, when executed by the processing circuitry individually or collectively, cause the electronic device to, based on that the source audio is determined to be outputted via the first speaker and the second speaker, based on a sensing value identified via the IV sensing circuitry, adjust an output level of a portion of the source audio. The instructions may be configured to, when executed by the processing circuitry individually or collectively, cause the electronic device to, based on that the source audio is determined to be outputted via the first speaker and the second speaker, transfer the source audio in which the output level of the portion is adjusted, to the first amplifier IC and the second amplifier IC via the audio interface. The instructions may be configured to, when executed by the processing circuitry individually or collectively, cause the electronic device to, based on that the source audio is determined to be outputted via the first speaker and the second speaker, control the first amplifier IC, such that the first amplifier IC outputs the first audio signal corresponding to the portion in which the output level of the source audio is adjusted, via the first speaker. The instructions may be configured to, when executed by the processing circuitry individually or collectively, cause the electronic device to, based on that the source audio is determined to be outputted via the first speaker and the second speaker, control the second amplifier IC, such that the second amplifier IC outputs the second audio signal corresponding to another portion in which the output level of the source audio is not adjusted, via the second speaker.

### [Description of the Drawings]

FIG. 1 is a block diagram of an electronic device in a network environment according to various embodiments.
FIG. 2 is a block diagram of an audio module according to various embodiments.
FIG. 3 is a block diagram of an electronic device according to an embodiment.
FIG. 4 is a block diagram related to audio signal processing of an electronic device according to an embodiment.
FIG. 5A is a diagram illustrating an operation in which an electronic device according to an embodiment processes an audio signal of a multi-channel.
FIG. 5B is a diagram illustrating an example of audio signals in which an electronic device according to an embodiment generates.
FIG. 5C is a diagram illustrating an example of an operation in which an electronic device according to an embodiment adjusts signal intensity of an audio signal.
FIG. 5D is a diagram illustrating another example of an operation in which an electronic device according to an embodiment adjusts signal intensity of an audio signal.
FIG. 6A is a diagram illustrating an operation in which an electronic device according to an embodiment outputs an audio signal through one speaker.
FIG. 6B is a diagram illustrating an operation in which an electronic device according to an embodiment outputs an audio signal through another speaker.
FIG. 7A is a block diagram related to audio signal processing of an electronic device according to an embodiment.
FIG. 7B is a block diagram related to audio signal processing of an electronic device according to an embodiment.
FIG. 8 is a block diagram of an electronic device according to an embodiment.
FIG. 9A is a diagram illustrating an operation in which an electronic device according to an embodiment processes an audio signal of a multi-channel.
FIG. 9B is a diagram illustrating an operation in which an electronic device according to an embodiment outputs an audio signal through one speaker.
FIG. 9C is a diagram illustrating an operation in which an electronic device according to an embodiment outputs an audio signal through one speaker.
FIG. 10A to FIG. 10C are diagrams illustrating a structure between an audio interface and codecs, included in an electronic device according to an embodiment.
FIG. 11A to FIG. 11C are flowcharts illustrating an operation of an electronic device according to an embodiment.
FIG. 12 is a flowchart illustrating an operation of an electronic device according to an embodiment.

### [Mode for Invention]

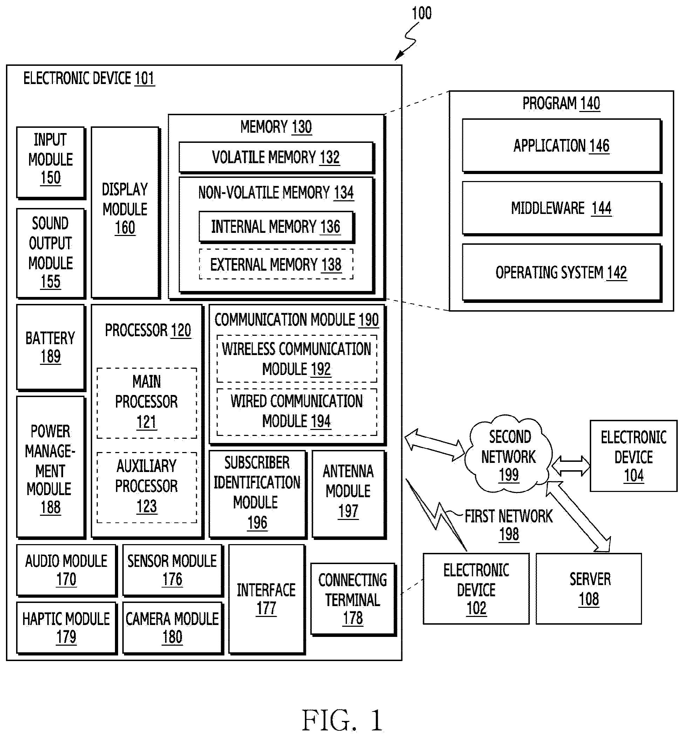

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

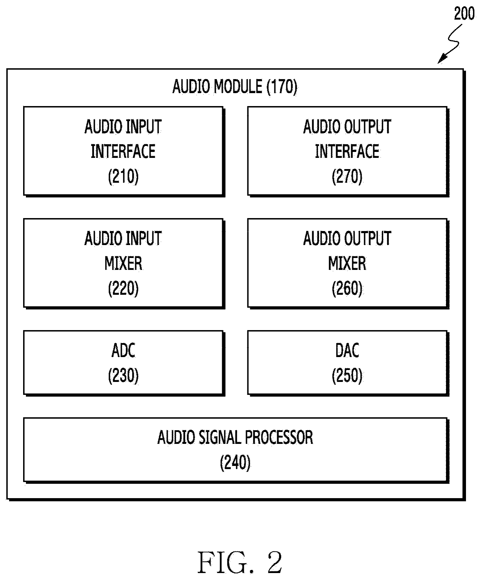

Fig. 2 is a block diagram 200 illustrating the audio module 170 according to various embodiments. Referring to Fig. 2, the audio module 170 includes, for example, an audio input interface 210, an audio input mixer 220, an analog-to-digital converter (ADC) 230, an audio signal processor 240, a digital-to-analog converter (DAC) 250, an audio output mixer 260, or an audio output interface 270.

The audio input interface 210 is operable to receive an audio signal corresponding to a sound obtained from the outside of the electronic device 101 via a microphone (e.g., a dynamic microphone, a condenser microphone, or a piezo microphone) that is configured as part of the input module 150 or separately from the electronic device 101. For example, if an audio signal is obtained from the external electronic device 102 (e.g., a headset or a microphone), the audio input interface 210 may be connected with the external electronic device 102 directly via the connecting terminal 178, or wirelessly (e.g., BluetoothTM communication) via the wireless communication module 192 to receive the audio signal. According to an embodiment, the audio input interface 210 is operable to receive a control signal (e.g., a volume adjustment signal received via an input button) related to the audio signal obtained from the external electronic device 102. The audio input interface 210 includes a plurality of audio input channels and is operable to receive a different audio signal via a corresponding one of the plurality of audio input channels, respectively. According to an embodiment, additionally or alternatively, the audio input interface 210 may be operable to receive an audio signal from another component (e.g., the processor 120 or the memory 130) of the electronic device 101.

The audio input mixer 220 is operable to synthesize a plurality of inputted audio signals into at least one audio signal. For example, according to an embodiment, the audio input mixer 220 is operable to synthesize a plurality of analog audio signals inputted via the audio input interface 210 into at least one analog audio signal.

The ADC 230 is operable to convert an analog audio signal into a digital audio signal. For example, according to an embodiment, the ADC 230 is operable to convert an analog audio signal received via the audio input interface 210 or, additionally or alternatively, an analog audio signal synthesized via the audio input mixer 220 into a digital audio signal.

The audio signal processor 240 is operable to perform various processing on a digital audio signal received via the ADC 230 or a digital audio signal received from another component of the electronic device 101. For example, according to an embodiment, the audio signal processor 240 is operable to perform changing a sampling rate, applying one or more filters, interpolation processing, amplifying or attenuating a whole or partial frequency bandwidth, noise processing (e.g., attenuating noise or echoes), changing channels (e.g., switching between mono and stereo), mixing, or extracting a specified signal for one or more digital audio signals. According to an embodiment, one or more functions of the audio signal processor 240 may be implemented in the form of an equalizer.

The DAC 250 is operable to convert a digital audio signal into an analog audio signal. For example, according to an embodiment, the DAC 250 is operable to convert a digital audio signal processed by the audio signal processor 240 or a digital audio signal obtained from another component (e.g., the processor(120) or the memory(130)) of the electronic device 101 into an analog audio signal.

The audio output mixer 260 is operable to synthesize a plurality of audio signals, which are to be outputted, into at least one audio signal. For example, according to an embodiment, the audio output mixer 260 is operable to synthesize an analog audio signal converted by the DAC 250 and another analog audio signal (e.g., an analog audio signal received via the audio input interface 210) into at least one analog audio signal.

The audio output interface 270 is operable to output an analog audio signal converted by the DAC 250 or, additionally or alternatively, an analog audio signal synthesized by the audio output mixer 260 to the outside of the electronic device 101 via the sound output module 155. The sound output module 155 may include, for example, a speaker, such as a dynamic driver or a balanced armature driver, or a receiver. According to an embodiment, the sound output module 155 may include a plurality of speakers. In such a case, the audio output interface 270 is operable to output audio signals having a plurality of different channels (e.g., stereo channels or 5.1 channels) via at least some of the plurality of speakers. According to an embodiment, the audio output interface 270 is connected with the external electronic device 102 (e.g., an external speaker or a headset) directly via the connecting terminal 178 or wirelessly via the wireless communication module 192 to output an audio signal.

According to an embodiment, the audio module 170 is operable to generate, without separately including the audio input mixer 220 or the audio output mixer 260, at least one digital audio signal by synthesizing a plurality of digital audio signals using at least one function of the audio signal processor 240.

According to an embodiment, the audio module 170 may include an audio amplifier (not shown) (e.g., a speaker amplifying circuit) that is capable of amplifying an analog audio signal inputted via the audio input interface 210 or an audio signal that is to be outputted via the audio output interface 270. According to an embodiment, the audio amplifier may be configured as a module separate from the audio module 170.

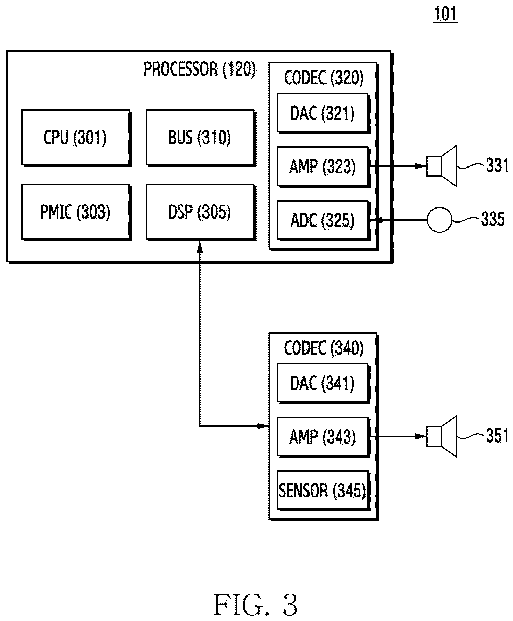

FIG. 3 is a block diagram of an electronic device according to an embodiment.

FIG. 3 may be described with reference to FIG. 1 and FIG. 2. An electronic device 101 of FIG. 3 may correspond to the electronic device 101 of FIG. 1.

Referring to FIG. 3, the electronic device 101 includse a processor 120, a codec 340, speakers 331 and 351, and a microphone 335. In an embodiment, the processor 120 of FIG. 3 may correspond to the processor 120 of FIG. 1. In an embodiment, the codec 340 of FIG. 3 is included as a portion of the audio module 170 of FIG. 1 and FIG. 2. In an embodiment, the speakers 331 and 351 of FIG. 3 are included as a portion of the sound output module 155 of FIG. 1. In an embodiment, the microphone 335 of FIG. 3 is included as a portion of the input module 150 of FIG. 1. In an embodiment, a codec may be referred to as an audio output integrated circuit (IC) or an amplifier (AMP) IC.

In an embodiment, the processor 120 includes a central processing unit (CPU) 301, a power management integrated circuit (PMIC) 303, a digital signal processor (DSP) 305, a bus 310, and a codec 320. In an embodiment, the CPU 301 may correspond to the main processor 121 of FIG. 1. In an embodiment, the PMIC 303 may correspond to the auxiliary processor 123 and/or the power management module 188 of FIG. 1. In an embodiment, the DSP 305 may correspond to the auxiliary processor 123 of FIG. 1 and/or the audio signal processor 240 of FIG. 2. In an embodiment, the bus 310 is operable to support data communication between components of the electronic device 101 through an electrical connection (or communication connection) between peripheral devices. In an embodiment, the codec 320 may be included as a portion of the audio module 170 of FIG. 1 and FIG. 2. In an embodiment, the codec 320 may be included as a portion of the CPU 301 (or the main processor 121) and/or the PMIC 303 (or the auxiliary processor 123, or the power management module 188).

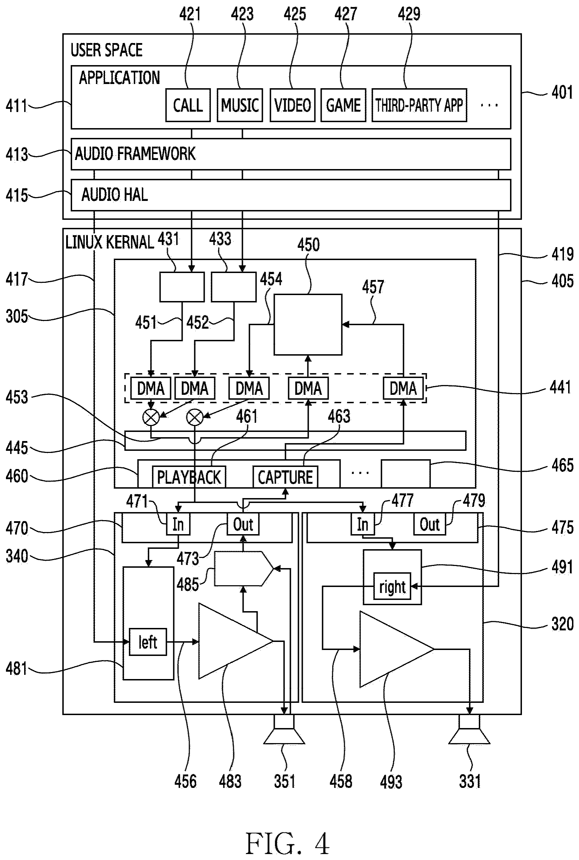

In an embodiment, the processor 120 (or the DSP 305) is electrically connected to the codecs 320 and 340. For example, the processor 120 (or the DSP 305) is electrically connected to the codecs 320 and 340 through one audio interface (e.g., an audio interface 460 of FIG. 4). However, it is not limited thereto. For example, the processor 120 (or the DSP 305) may be electrically connected to the codecs 320 and 340 through a plurality of audio interfaces, respectively.

In an embodiment, the processor 120 (or the DSP 305) is operable to process a sample rate, a bit number, and/or a channel of a digital audio signal (or pulse code modulation data).

In an embodiment, the processor 120 (or the DSP 305) is operable to transmit an audio signal to the codecs 320 and 340 through one audio interface. In an embodiment, the processor 120 (or the DSP 305) is operable to transmit the same audio signal to the codecs 320 and 340 through one audio interface.

In an embodiment, the codec 320 may include a digital to analog converter (DAC) 321, an amplifier (AMP) 323, and/or an analog to digital converter (ADC) 325.

In an embodiment, the DAC 321 may correspond to the DAC 250 of FIG. 2. In an embodiment, the DAC 321 may convert a digital audio signal into an analog audio signal. In an embodiment, the DAC 321 may extract (or select) an audio signal of at least one channel among audio signals corresponding to a plurality of channels included in the audio signal based on control by the processor 120. In an embodiment, the DAC 321 may mix the audio signals corresponding to the plurality of channels included in the audio signal based on the control by the processor 120.

In an embodiment, the AMP 323 may amplify an audio signal to be outputted through the speaker 331. In an embodiment, the AMP 323 may amplify the audio signal obtained from the DAC 321. In an embodiment, the speaker 331 may be connected to the codec 320 (or the AMP 323) and may convert the audio signal into sound.

In an embodiment, the ADC 325 may correspond to the ADC 230 of FIG. 2. In an embodiment, the ADC 325 may convert an analog audio signal into a digital audio signal. In an embodiment, the ADC 325 may convert the analog audio signal obtained from the microphone 335 into the digital audio signal.

In an embodiment, the codec 340 may include a DAC 341, an AMP 343, and/or a sensor 345.

In an embodiment, the DAC 341 may correspond to the DAC 250 of FIG. 2. In an embodiment, the DAC 341 may convert a digital audio signal into an analog audio signal. In an embodiment, the DAC 341 may extract (or select) an audio signal of at least one channel among the audio signals corresponding to the plurality of channels included in the audio signal based on the control by the processor 120. In an embodiment, the DAC 341 may mix the audio signals corresponding to the plurality of channels included in the audio signal based on the control by the processor 120.

In an embodiment, the AMP 343 may amplify an audio signal to be outputted through the speaker 351. In an embodiment, the AMP 343 may amplify the audio signal obtained from the DAC 341. In an embodiment, the speaker 351 may be connected to the codec 340 (or the AMP 343) and may convert the audio signal into sound.

In an embodiment, the sensor 345 may detect an operating state (e.g., power, voltage, and/or current) of the codec 340 and generate data corresponding to a detected state. In an embodiment, the sensor 345 may detect intensity (or voltage, and/or a current) of an audio signal outputted through the AMP 343 and generate data corresponding to a detected state. In an embodiment, the sensor 345 may detect intensity (or voltage or a current) of an audio signal inputted to the speaker 351 and generate data corresponding to a detected state.

As described above, the electronic device 101 may include heterogeneous codecs 320 and 340. As described above, in case that the electronic device 101 electrically connects the heterogeneous codecs 320 and 340 to the processor 120 (or the DSP 305) through one audio interface (e.g., the audio interface included in the DSP 305), the same audio signal may be transmitted to the codecs 320 and 340. In this case, in case that the same audio signal is transmitted to the heterogeneous codecs 320 and 340, as the adjusted audio signal is equally transmitted to the codecs 320 and 340, a situation that the codec 320 in which the audio signal does not need to be adjusted outputs a larger or smaller sound through the speaker 331 may occur. Additionally, in case that the same audio signal is transmitted to the heterogeneous codecs 320 and 340, as an unadjusted audio signal is equally transmitted to the codecs 320 and 340, a situation that causes damage to the speaker 351 by the audio signal transmitted through the codec 340 that requires adjustment of the audio signal may occur.

Hereinafter, referring to FIG. 4 to FIG. 6B, an operation in which the codecs 320 and 340 output different audio signals through the speakers 331 and 351, even when the electronic device electrically connects the heterogeneous codecs 320 and 340 to the DSP 305 through one audio interface (e.g., the audio interface included in the DSP 305) may be described.

FIG. 4 is a block diagram related to audio signal processing of an electronic device according to an embodiment.

FIG. 4 may be described with reference to FIG. 1 to FIG. 3.

Referring to FIG. 4, an electronic device 101 may execute programs (e.g., 411, 413, and 415). For example, the electronic device 101 may execute an application 411, an audio framework 413, and/or an audio hardware abstraction layer (HAL) 415 through a processor 120. For example, electronic device 101 may execute the application 411, the audio framework 413, and/or the audio HAL 415 in a user space 401. In an embodiment, at least one of the programs (e.g., 411, 413, and 415) executed in the user space 401 may be assigned an independent memory area from memory 130. The memory area being independent may indicate that another process other than a process assigned in the memory area cannot access.

In an embodiment, the processor 120 may execute the application 411 (or a call 421, a music 423, a video 425, a game 427, and/or a third-party app 429). In an embodiment, the processor 120 may identify a request of the application 411 based on executing the application 411 (or the call 421, the music 423, the video 425, the game 427, and/or the third-party app 429). In an embodiment, based on a request (e.g., an audio playback request) from the application 411, the processor 120 may execute the audio framework 413 and/or the audio HAL 415 for processing the request.

In an embodiment, the electronic device 101 may control components (or hardware) of the electronic device 101. For example, the electronic device 101 may execute programs (e.g., a device driver) for controlling the components (or the hardware) of the electronic device 101 through the processor 120. For example, the electronic device 101 may execute programs for controlling a DSP 305 and/or codecs 320 and 340 in a kernel 405 (or a Linux kernel). In an embodiment, the programs executed in the kernel 405 may share the memory area of the memory 130. The memory area being shared may indicate that processes of the programs executed in the kernel 405 may access a memory area of other processes of other programs executed in kernel 405. Hereinafter, the DSP 305 and the codecs 320 and 340 in the kernel 405 may indicate the programs (e.g., the device driver) and/or the hardware. According to an embodiment, FIG. 4 is a diagram illustrating at least one hardware component controlled by at least one program included in the kernel 405.

In an embodiment, the DSP 305 may include PCM playbacks 431 and 433. The PCM playbacks 431 and 433 are file nodes, and audio (e.g., an audio file) may be recorded. In an embodiment, the application 411 may record an audio file indicating an audio signal to be outputted through speakers 331 and 351 in the PCM playbacks 431 and 433 assigned to itself.

In an embodiment, the DSP 305 may include direct memory accesses 441 and a bus 445.

In an embodiment, the DMAs 441 are memories in the DSP 305 and may store data for data transfer between components in the DSP 305. In an embodiment, the DMAs 441 may transfer data from components outside the DSP 305 to inside the DSP 305, or may transfer data from components inside the DSP 305 to the components outside the DSP 305.

In an embodiment, the DMAs 441 may be included in the memory 130.

In an embodiment, the DMAs 441 may read data (or the audio file recorded in the PCM Playbacks 431 and 433) requested by the processor 120 (or the DSP 305). In an embodiment, audio signals generated through different applications (e.g., the music 423 and the video 425) may be mixed through a signal transmission path 451 from the PCM Playback 431 to the DMA and a signal transmission path 452 from the PCM Playback 433 to the DMA. For example, an audio signal that includes audio signals in the same channel by mixing may be generated. For example, an audio signal that includes audio signals in different channels by mixing may be generated. However, it is not limited thereto. In the user space 401, a source of the audio signal for which output is requested may be one.

In an embodiment, the DMAs 441 may transfer data (or the audio file recorded in the PCM Playbacks 431 and 433) read through the bus 445 to an amplifier (AMP) solution 450. In an embodiment, the mixed audio signal may be transferred to the AMP solution 450 through a signal transmission path 453.

In an embodiment, the AMP solution 450 may adjust a portion (or an audio signal on a designated first channel) of the mixed audio signal. In an embodiment, the AMP solution 450 may adjust the portion (or the audio signal on the designated first channel) of the mixed audio signal based on sensing data transferred from a sensor 485 through a signal transmission path 457.

In an embodiment, the AMP solution 450 may transfer the processed audio signal to DACs 481 and 491 of the codecs 320 and 340 through a signal transmission path 454. In an embodiment, the DMAs 441 may obtain (or read) data from the AMP solution 450. In an embodiment, the DMAs 441 may transfer the obtained (or read) data from the AMP solution 450 to the codecs 320 and 340 through the bus 445.

In an embodiment, the processor 120 (or the DSP 305) may include audio interfaces 460 and 465. For example, the audio interface 460 among the audio interfaces 460 and 465 may be electrically connected to input terminals 471 and 477 of audio interfaces 470 and 475 of the codecs 320 and 340 through a playback interface 461. For example, the audio interface 460 among the audio interfaces 460 and 465 may be electrically connected to an output terminal 473 of the audio interface 470 of the codec 340 among the codecs 320 and 340 through a capture interface 463. In an embodiment, the audio interfaces 460 and 465 may be integrated interchip sound (I2S), and/or a serial peripheral interface (SPI).

In an embodiment, the codec 340 may include the audio interface 470, the DAC 481, an AMP 483, and the sensor 485. In an embodiment, the DAC 481, the AMP 483, and the sensor 485 may respectively correspond to the DAC 341, the AMP 343, and the sensor 345 of FIG. 3.

In an embodiment, the audio interface 470 may include the input terminal 471 and the output terminal 473. In an embodiment, the audio interface 470 may be electrically connected to the playback terminal 461 of the audio interface 460 through the input terminal 471. In an embodiment, the audio interface 470 may be electrically connected to the capture terminal 463 of the audio interface 460 through the output terminal 473.

In an embodiment, the DAC 481 may be controlled based on a control signal generated from the application 411, the audio framework 413, and/or the audio HAL 415. For example, the DAC 481 may perform selecting (e.g., extracting of a designated signal) of a channel of an audio signal, and/or mixing of the audio signal, based on the control signal.

In an embodiment, the DAC 481 may transfer the audio signal to the AMP 483.

In an embodiment, the AMP 483 may amplify the audio signal outputted from the DAC 481 by a designated ratio (or by intensity designated by volume control). In an embodiment, the AMP 483 may output the amplified audio signal through the speaker 351. For example, the amplified audio signal transferred through a signal transmission path 456 from the DAC 481 to the speaker 351 may be outputted as sound through the speaker 351.

In an embodiment, the sensor 485 may detect intensity (or voltage, and/or a current) of the audio signal outputted through the AMP 483 and generate data corresponding to a detected state. In an embodiment, the sensor 485 may detect intensity (or voltage or a current) of the audio signal inputted to the speaker 351 and generate data corresponding to the detected state.

In an embodiment, the codec 340 may select a portion (e.g., the audio signal on the designated first channel) of the adjusted audio signal processed through the DAC 481. In an embodiment, the DAC 481 may select the portion (e.g., the audio signal on the designated first channel) of the adjusted audio signal from an audio signal processed through a control signal 417. In an embodiment, the control signal 417 may be transferred in software from the processor 120 (or the DSP 305) to the codec 340 through the audio framework 413 and the audio HAL 415. In an embodiment, the control signal 417 may be physically transferred from the processor 120 (or the DSP 305) to the codec 340 through an inter-integrated circuit (I2C). In an embodiment, the control signal 417 may include information (e.g., channel 0, channel 1) on a channel that the codec 340 should select from among multi-channels (or two channels).

In an embodiment, the DMAs 441 may obtain (or read) data from the codec 340 through the bus 445. In an embodiment, the DMAs 441 may transfer data obtained (or read) from the codec 340 through the bus 445 to the AMP solution 450. In an embodiment, the sensing data from the sensor 485 may be transferred to the AMP solution 450 through the signal transmission path 457.

In an embodiment, the codec 320 may include the audio interface 475, the DAC 491, and the AMP 493. In an embodiment, the DAC 481 and the AMP 483 may respectively correspond to the DAC 321 and the AMP 323 of FIG. 3.

In an embodiment, the audio interface 475 may include the input terminal 477 and an output terminal 479. In an embodiment, the audio interface 475 may be electrically connected to the playback terminal 461 of the audio interface 460 through the input terminal 477.

In an embodiment, the DAC 491 may be controlled based on a control signal 419 generated from the application 411, the audio framework 413, and/or the audio HAL 415. For example, the DAC 491 may perform selecting (e.g., extracting of a designated signal) of a channel of an audio signal and/or mixing of the audio signal based on the control signal 419.

In an embodiment, the DAC 491 may transfer the audio signal to the AMP 493.

In an embodiment, the AMP 493 may amplify the audio signal outputted from the DAC 491 by a designated ratio (or by intensity designated by volume control). In an embodiment, the AMP 493 may output the amplified audio signal through the speaker 331. For example, the amplified audio signal transferred through a signal transmission path 458 from the DAC 491 to the speaker 331 may be outputted as sound through the speaker 331.

In an embodiment, the codec 320 may select another portion (e.g., an audio signal on a designated second channel), which is not adjusted, of the audio signal processed through the DAC 491. In an embodiment, the DAC 491 may select the another portion (e.g., the audio signal on the designated second channel), which is not adjusted, of the audio signal processed through the control signal 419. In an embodiment, the control signal 419 may be transferred in software from the processor 120 (or the DSP 305) to the codec 340 through the audio framework 413 and the audio HAL 415. In an embodiment, the control signal 419 may be physically transferred from the processor 120 (or the DSP 305) to the codec 320 through the I2C. In an embodiment, the control signal 419 may include information (e.g., channel 0, channel 1) on a channel that the codec 320 should select from among multi-channels (or two channels).

Hereinafter, an operation in which the codecs 320 and 340 output different audio signals through the speakers 331 and 351, through control of the processor 120 (or the DSP 305) may be described.

In an embodiment, the processor 120 (or the DSP 305) may identify source audio. In an embodiment, the processor 120 (or the DSP 305) may identify audio signals generated through different applications (e.g., the music 423 and the video 425) as the source audio. In an embodiment, the processor 120 (or the DSP 305) may identify the mixed audio signal obtained through the signal paths 451, 452, and 453 as the source audio. In an embodiment, the source audio may be a multi-channel audio signal (e.g., a stereo audio signal, or a 5.1 channel audio signal) that includes different audio signals on different frequency ranges. For example, the source audio may be a stereo audio signal that includes a first audio signal on a first frequency range (or channel) and a second audio signal on a second frequency range (or channel) not overlapping the first frequency range. For example, the source audio may be Pulse-code modulation (PCM) data.

In an embodiment, the processor 120 (or the DSP 305) may determine a speaker to which the source audio is to be outputted among the speakers 331 and 351. In an embodiment, the processor 120 (or the DSP 305) may determine the speaker to which the source audio is to be outputted among the speakers 331 and 351 based on a characteristic (mono or multi-channel audio signal) of the source audio. In an embodiment, the processor 120 (or the DSP 305) may determine the speaker to which the source audio is to be outputted among the speakers 331 and 351 based on information included in an output request of the source audio of the application.

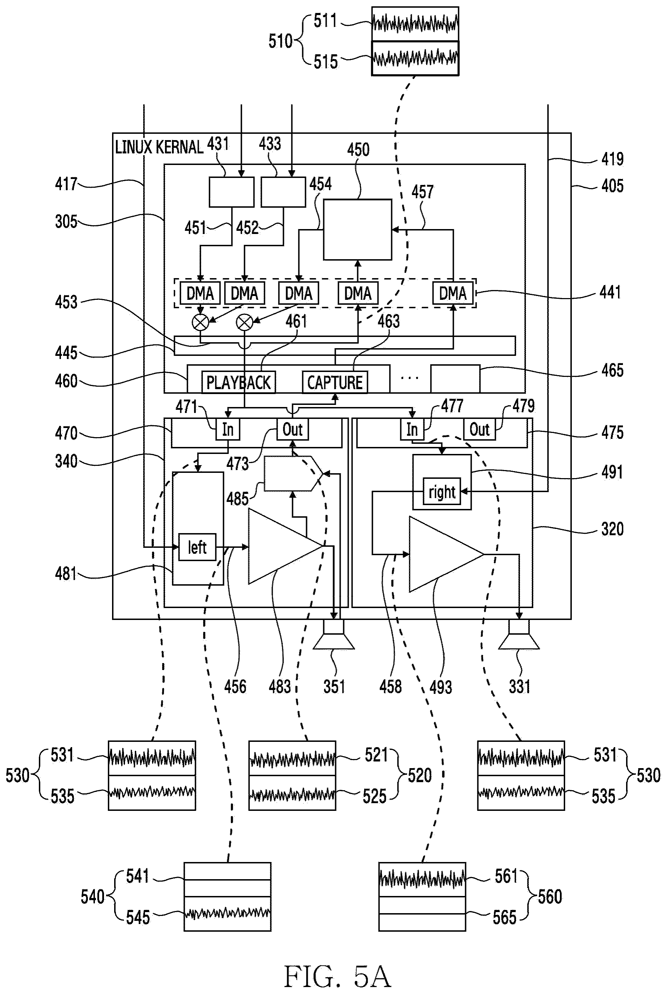

In an embodiment, the processor 120 (or the DSP 305) may determine that the source audio is outputted through the speaker 351 and the speaker 331. Operations in which the source audio is outputted through the speaker 351 and the speaker 331 may be described in detail through FIG. 5A to FIG. 5D.

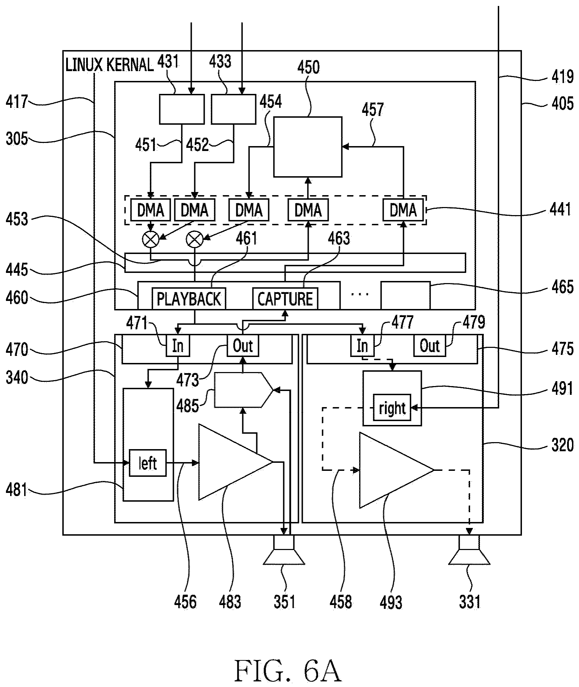

In an embodiment, the processor 120 (or the DSP 305) may determine that the source audio is outputted through the speaker 351. Operations in which the source audio is outputted through the speaker 351 may be described in detail through FIG. 6A.

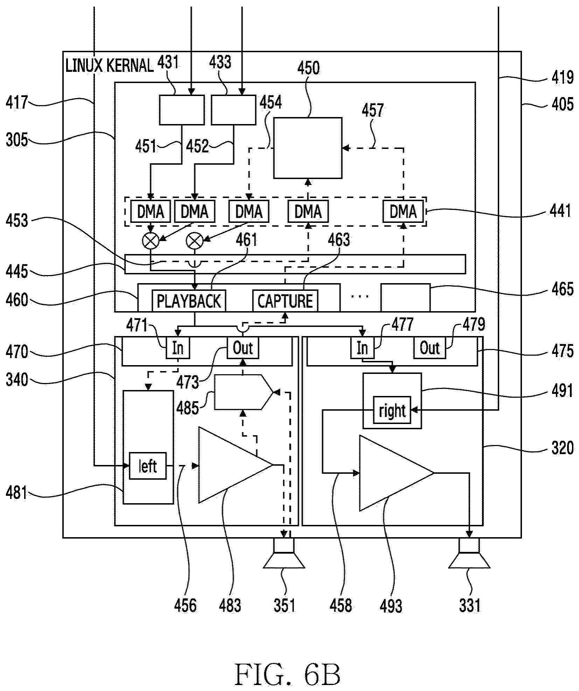

In an embodiment, the processor 120 (or the DSP 305) may determine that the source audio is outputted through the speaker 331. Operations in which the source audio is outputted through the speaker 351 may be described in detail through FIG. 6B.

In an embodiment, the processor 120 (or the DSP 305) may obtain sensing data (or a sensing value) from the codec 340 through the audio interface 460. In an embodiment, the processor 120 (or the DSP 305) may obtain the sensing data from the codec 340 through the audio interface 460 based on determining that the source audio is outputted from the speaker 351. In an embodiment, the processor 120 (or the DSP 305) may obtain the sensing data transferred from the sensor 485 through the signal transmission path 457. In an embodiment, the sensing data may be identified by the sensor 485 in the codec 340 in relation to output of an audio through the speaker 351. In an embodiment, the sensing data may indicate intensity (or voltage, and/or a current) of the audio signal outputted through AMP 343 and/or intensity (or voltage, and/or a current) of the audio signal inputted to the speaker 351.

In an embodiment, the processor 120 (or the DSP 305) may adjust a portion of the source audio based on the sensing data (or the sensing value) identified through the sensor 485. In an embodiment, the processor 120 (or the DSP 305) may adjust the first audio signal on the first channel to be outputted through the speaker 351 among audio signals included in the source audio. In an embodiment, the processor 120 (or the DSP 305) may adjust the first audio signal on the first channel based on applying the sensing data to the first audio signal on the first channel among the first audio signal on the first channel and the second audio signal on the second channel included in the source audio. In an embodiment, the processor 120 (or the DSP 305) may not adjust the second audio signal on the second channel to be outputted through the speaker 331 among the audio signals included in the source audio. In an embodiment, the processor 120 (or the DSP 305) may compare a level of source audios transferred from the user space 401 with the sensing data identified through the sensor 485. Based on a comparison result, the processor 120 (or the DSP 305) may adjust an output level of the source audio to a stable level, and transfer the source audio in which the output level is adjusted to the codecs 320 and 340. In an embodiment, the source audio (or the PCM data) on the user space 401 may include music sound and call sound, and/or game sound.

In an embodiment, the processor 120 (or the DSP 305) may adjust the output level of the first audio signal on the first channel of the source audio based on the sensing value identified through the sensor 485. For example, the processor 120 (or the DSP 305) may adjust signal intensity of an audio interval having signal intensity exceeding threshold signal intensity among a plurality of audio intervals of the first audio signal, based on the sensing value identified through the sensor 485. For example, the processor 120 (or the DSP 305) may adjust the signal intensity of the audio interval having the signal intensity exceeding the threshold signal intensity among the plurality of audio intervals (or time intervals) of the first audio signal to less than or equal to the threshold signal intensity based on the sensing value identified through the sensor 485. However, it is not limited thereto. For example, the processor 120 (or the DSP 305) may reduce the signal intensity of the first audio signal by a designated value (or by a designated ratio) based on identifying that the first audio signal at least partially exceeds the threshold signal intensity based on the sensing value identified through the sensor 485.

In an embodiment, the processor 120 (or the DSP 305) may provide, to each of the codec 340 and the codec 320, an audio signal including the adjusted first audio signal on the first channel and the second audio signal on the second channel through the audio interface 460. In an embodiment, the processor 120 (or the DSP 305) may simultaneously transfer the audio signal to the codec 340 and the codec 320 through the playback terminal 461 of the audio interface 460. In an embodiment, the processor 120 (or the DSP 305) may simultaneously transfer the audio signal to the codec 340 and the codec 320 through the signal transmission path 454.

In an embodiment, the codec 340 may identify, from the audio signal, the adjusted first audio signal on the first channel for first audio to be outputted through the speaker 351. For example, the codec 340 may identify, from the audio signal, the adjusted first audio signal on the first channel for the first audio to be outputted through speaker 351 based on the control signal from the processor 120 (or the DSP 305).

In an embodiment, the codec 340 may transfer the adjusted first audio signal on the first channel to the AMP 483. In an embodiment, the codec 340 may transfer the audio signal amplified in the AMP 483 to the speaker 351 through the signal transmission path 456 from the DAC 481 to the speaker 351. For example, the speaker 351 may output the amplified audio signal as sound.

In an embodiment, the codec 320 may identify, from the audio signal, the unadjusted second audio signal on the second channel for second audio to be outputted through the speaker 331. For example, the codec 320 may identify, from the audio signal, the unadjusted second audio signal on the second channel for the second audio to be outputted through the speaker 331 based on the control signal from the processor 120 (or the DSP 305).

In an embodiment, the codec 320 may transfer the unadjusted second audio signal on the second channel to the AMP 493. In an embodiment, the codec 320 may transfer the audio signal amplified in the AMP 493 to the speaker 331 through the signal transmission path 458 from the DAC 491 to the speaker 331. For example, the speaker 331 may output the amplified audio signal as sound.

As described above, the electronic device 101 may control the heterogeneous codecs 320 and 340 so that the heterogeneous codecs 320 and 340 select an audio signal of a designated channel from among the same audio signal and output the selected audio signal. Accordingly, the electronic device 101 may provide a necessary audio signal to the codec 340 that requires adjustment of the audio signal, and may provide a necessary audio signal to the codec 320 that does not require the adjustment of the audio signal.

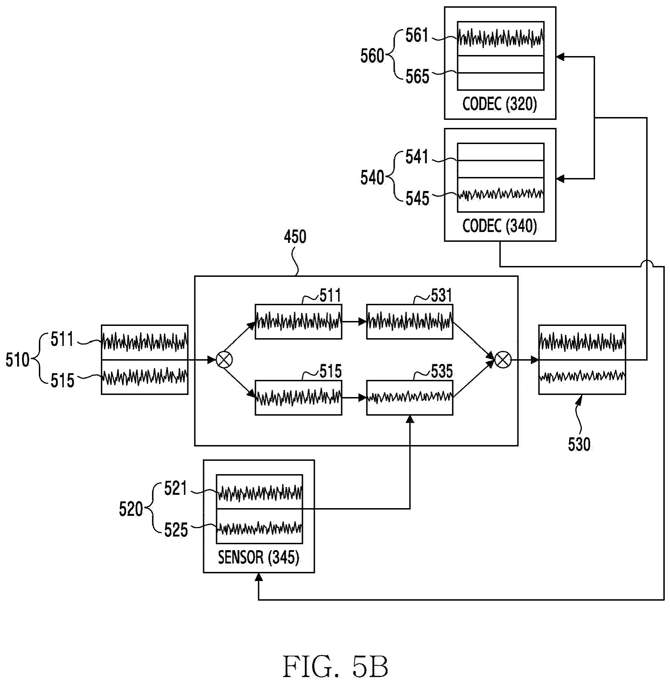

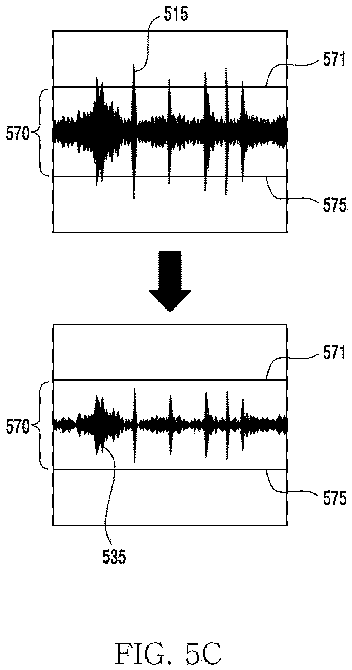

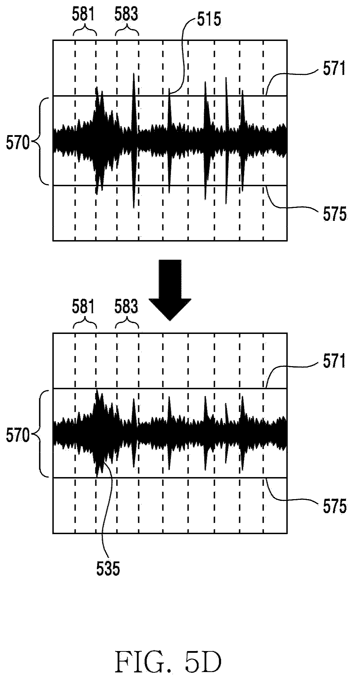

FIG. 5A is a diagram illustrating an operation in which an electronic device according to an embodiment processes an audio signal of a multi-channel. FIG. 5B is a diagram illustrating an example of audio signals in which an electronic device according to an embodiment generates. FIG. 5C is a diagram illustrating an example of an operation in which an electronic device according to an embodiment adjusts signal intensity of an audio signal. FIG. 5D is a diagram illustrating another example of an operation in which an electronic device according to an embodiment adjusts signal intensity of an audio signal.

FIG. 5A to FIG. 5D may be described with reference to FIG. 1 to FIG. 4. Among the descriptions of FIG. 5A to FIG. 5D, the same description as that of FIG. 4 may not be repeated.

Referring to FIG. 5A, a processor 120 (or a DSP 305) may identify source audio 510. In an embodiment, the source audio 510 may be a stereo audio signal that includes a first audio signal 515 on a first frequency range (or, a first channel) and a second audio signal 511 on a second frequency range (or, a second channel) not overlapping the first frequency range. However, it is not limited thereto. The source audio 510 may be a multi-channel audio signal (e.g., a 5.1 channel audio signal).

In an embodiment, the processor 120 (or the DSP 305) may obtain sensing data 520 from a codec 340 through an audio interface 460. In an embodiment, the sensing data 520 may include current data 521 and voltage data 525. In an embodiment, the sensing data 520 may include the current data 521 in the second channel and the voltage data 525 in the first channel. In an embodiment, the sensing data 520 may include the current data 521 and the voltage data 525 of an AMP 483 and/or a speaker 351 caused by a first audio signal 545.

In an embodiment, the processor 120 (or the DSP 305) may adjust the first audio signal 515 on the first channel to be outputted through the speaker 351 among the audio signals 511 and 515 included in the source audio 510 based on the sensing data 520. In an embodiment, the processor 120 (or the DSP 305) may not adjust the second audio signal 511 on the second channel to be outputted through a speaker 331 among the audio signals 511 and 515 included in the source audio 510.

Referring to FIG. 5B, an AMP solution 450 of the processor 120 (or the DSP 305) may adjust the first audio signal 515 of the source audio 510 based on the sensing data 520. For example, referring to FIG. 5C, in case that the first audio signal 515 exceeds threshold signal intensity 571 or 570, the AMP solution 450 may generate an adjusted first audio signal 535 by reducing signal intensity of the first audio signal to within a designated signal intensity range 570, based on the sensing data 520. For example, referring to FIG. 5D, the AMP solution 450 may adjust signal intensity of an audio interval 583 having signal intensity exceeding the threshold signal intensity 571 or 575 among a plurality of audio intervals 581 and 583 of the first audio signal to within the signal intensity range 570, based on the sensing data 520.

Referring back to FIG. 5A, the processor 120 (or the DSP 305) may provide, to each the codec 340 and a codec 320, an audio signal 530 including the adjusted first audio signal 535 on the first channel and a second audio signal 531 on the second channel.

In an embodiment, the codec 340 may identify, from the audio signal 530, the adjusted first audio signal 535 on the first channel for first audio to be outputted through the speaker 351. In an embodiment, the codec 340 may filter, from the audio signal 530, the second audio signal 531 on the second channel that is not to be outputted through the speaker 351. For example, the codec 340 may generate an audio signal 540 including only the first audio signal 545 without a second audio signal 541 by filtering the second audio signal 531. In an embodiment, the speaker 351 may output the audio signal 540 including only the first audio signal 545 as sound.

In an embodiment, the codec 320 may identify, from the audio signal 530, the unadjusted second audio signal 531 on the second channel for second audio to be outputted through the speaker 331. In an embodiment, the codec 320 may filter, from the audio signal 530, the first audio signal 535 on the first channel that is not be outputted through the speaker 331. For example, the codec 320 may generate an audio signal 560 including only a second audio signal 561 without a first audio signal 565 by filtering the first audio signal 535. In an embodiment, the speaker 331 may output the audio signal 560 including only the second audio signal 561 as sound.

FIG. 6A is a diagram illustrating an operation in which an electronic device according to an embodiment outputs an audio signal through one speaker.

FIG. 6A may be described with reference to FIG. 1 to FIG. 4. Among the descriptions of FIG. 6A, the same description as that of FIG. 4 may not be repeated.

In an embodiment, a processor 120 (or a DSP 305) may identify source audio. In an embodiment, the processor 120 (or the DSP 305) may determine a speaker to which the source audio is to be outputted among speakers 331 and 351.

In an embodiment, the processor 120 (or the DSP 305) may determine that the source audio is outputted through the speaker 351. In an embodiment, as it is determined that the source audio is not outputted through the speaker 331, the processor 120 (or, the DSP 305) (or, the processor 120) may turn off a codec 320.

In an embodiment, the processor 120 (or the DSP 305) may obtain sensing data (or a sensing value) from a codec 340 through an audio interface 460. In an embodiment, the processor 120 (or the DSP 305) may adjust a portion of the source audio based on the sensing data (or the sensing value) identified through a sensor 485. In an embodiment, the processor 120 (or the DSP 305) may adjust a first audio signal on a first channel to be outputted through the speaker 351 among audio signals included in the source audio. In an embodiment, the source audio may not include a second audio signal on a second channel.

In an embodiment, the processor 120 (or the DSP 305) may provide, to each of the codec 340 and the codec 320, an audio signal including the adjusted first audio signal on the first channel through the audio interface 460. In an embodiment, as the codec 320 is turned off, the codec 320 may not process the audio signal including the first audio signal.

In an embodiment, the codec 340 may identify, from the audio signal, the adjusted first audio signal on the first channel for first audio to be outputted through the speaker 351. In an embodiment, the codec 340 may mix in mono the adjusted first audio signal on the first channel. For example, the codec 340 may mix in mono the adjusted first audio signal on the first channel for the first audio to be outputted through the speaker 351 based on a control signal from the processor 120 (or the DSP 305). For example, the mixing in mono may include processing audio signals on different channels to be outputted through one speaker. For example, the mixing in mono may include mixing the audio signals on the different channels into one audio signal.

In an embodiment, the codec 340 may transfer the mono-mixed first audio signal on the first channel to an AMP 483. In an embodiment, the codec 340 may transfer the audio signal amplified in the AMP 483 to the speaker 351 through a signal transmission path 456 from a DAC 481 to the speaker 351. For example, the speaker 351 may output the amplified audio signal as sound.

FIG. 6B is a diagram illustrating an operation in which an electronic device according to an embodiment outputs an audio signal through another speaker.

FIG. 6B may be described with reference to FIG. 1 to FIG. 4. Among the descriptions of FIG. 6B, the same description as that of FIG. 4 may not be repeated.

In an embodiment, a processor 120 (or a DSP 305) may identify source audio. In an embodiment, the processor 120 (or the DSP 305) may determine a speaker to which the source audio is to be outputted among speakers 331 and 351.

In an embodiment, the processor 120 (or the DSP 305) may determine that the source audio is outputted through the speaker 331. In an embodiment, as it is determined that the source audio is not outputted through the speaker 351, the processor 120 (or the DSP 305) (or the processor 120) may turn off a codec 340. In an embodiment, the processor 120 (or the DSP 305) (or the processor 120) may bypass an AMP solution 450. For example, bypassing the AMP solution 450 may mean that the source audio is not transferred to the AMP solution 450 but is inputted to codecs 320 and 340 through an audio interface 460.

In an embodiment, the codec 320 may identify, from the audio signal, a second audio signal on a second channel for second audio to be outputted through the speaker 331. In an embodiment, the codec 320 may mix in mono the second audio signal on the second channel. For example, the codec 320 may mix in mono the second audio signal on the second channel for the second audio to be outputted through speaker 331 based on a control signal from the processor 120 (or the DSP 305).

In an embodiment, the codec 320 may transfer the mono-mixed second audio signal on the second channel to an AMP 493. In an embodiment, the codec 320 may transfer the audio signal amplified by the AMP 483 to the speaker 331 through a signal transmission path 458 from a DAC 491 to the speaker 331. For example, the speaker 331 may output the amplified audio signal as sound.

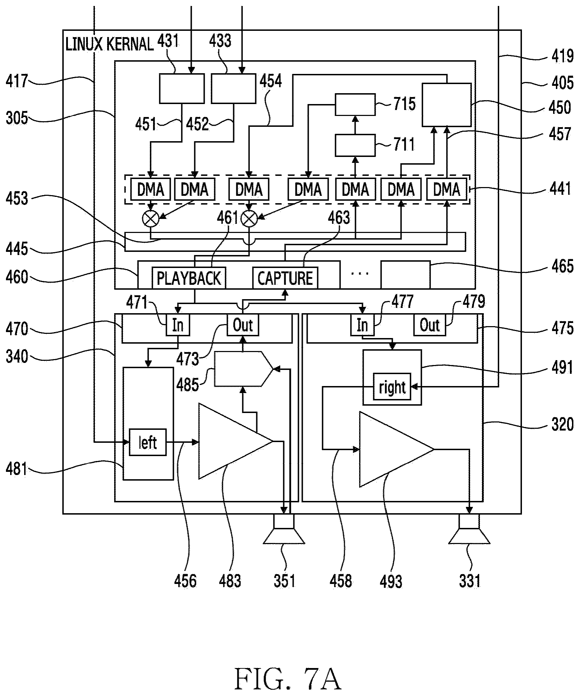

FIG. 7A is a block diagram related to audio signal processing of an electronic device according to an embodiment.

FIG. 7A may be described with reference to FIG. 1 to FIG. 4. Among the descriptions of FIG. 7A, the same description as that of FIG. 4 may not be repeated.

Compared with the DSP 305 of FIG. 4, a DSP 305 of FIG. 7A may further include a channel selector 711 and a time synchronization unit 715.

In an embodiment, the channel selector 711 may identify an unadjusted second audio signal on a second channel for second audio to be outputted through a speaker 331 from source audio. In an embodiment, the channel selector 711 may identify the unadjusted second audio signal on the second channel for the second audio to be outputted through the speaker 331 from the source audio based on determining that the source audio is outputted through a speaker 351 and the speaker 331. In an embodiment, the channel selector 711 may filter a first audio signal on a first channel that is not be outputted through the speaker 331 from the source audio. In an embodiment, the channel selector 711 may generate an audio signal including only the second audio signal without the first audio signal by filtering the first audio signal.

In an embodiment, in case that only one codec 340 of codecs 320 and 340 includes a sensor 485, a processor 120 (or a DSP 305) may adjust an audio signal for the codec 340 through an AMP solution 450. In an embodiment, in case that the only one codec 340 of the codecs 320 and 340 includes the sensor 485, the processor 120 (or the DSP 305) may perform reading (e.g., reading through DMAs 441) of the audio signal for the codec 320 to memory 130 (or a buffer in the processor 120 (or the DSP 305)) without processing it through the AMP solution 450. Then, in an embodiment, in case that the only one codec 340 of the codecs 320 and 340 includes the sensor 485, the processor 120 (or the DSP 305) may synchronize a timing of the read audio signal for the codec 320 with the audio signal for the codec 340 through the time synchronization unit 715, and then mix it in stereo with the audio signal for the codec 340. Herein, mixing in stereo may include processing of mixing audio signals on different channels.

In an embodiment, the time synchronization unit 715 may synchronize a playback time of the second audio signal on the second channel received from the channel selector 711 to a playback time of the adjusted first audio signal on the first channel for the first audio. In an embodiment, the time synchronization unit 715 may adjust (or delay) the playback time of the second audio signal based on time required to adjust the first audio signal such that the second audio signal and the adjusted first audio signal are synchronized each other. However, it is not limited thereto. For example, the time synchronization unit 715 may adjust (or delay) the playback time of the second audio signal such that a timestamp of the second audio signal on the second channel and a timestamp of the adjusted first audio signal correspond to each other.

In an embodiment, the processor 120 (or the DSP 305) may simultaneously transfer an audio signal including the second audio signal on the second channel in which the playback time is delayed (or synchronized) and the adjusted first audio signal on the first channel, to the codec 340 and 320 through a signal transmission path 454.

In an embodiment, the codec 340 may identify the adjusted first audio signal on the first channel for the first audio to be outputted through the speaker 351 from the audio signal including the second audio signal on the second channel in which the playback time is delayed (or synchronized) and the adjusted first audio signal on the first channel. In an embodiment, the codec 340 may transfer the adjusted first audio signal on the first channel to the speaker 351 through an AMP 483. In an embodiment, the speaker 351 may output the amplified audio signal through the AMP 483 as sound.

In an embodiment, the codec 320 may identify the second audio signal on the second channel for the second audio to be outputted through the speaker 331 from the audio signal including the second audio signal on the second channel in which the playback time is delayed (or synchronized) and the adjusted first audio signal on the first channel. In an embodiment, the codec 320 may transfer the second audio signal on the second channel to the speaker 331 through an AMP 493. In an embodiment, the speaker 331 may output the amplified audio signal through the AMP 493 as sound.

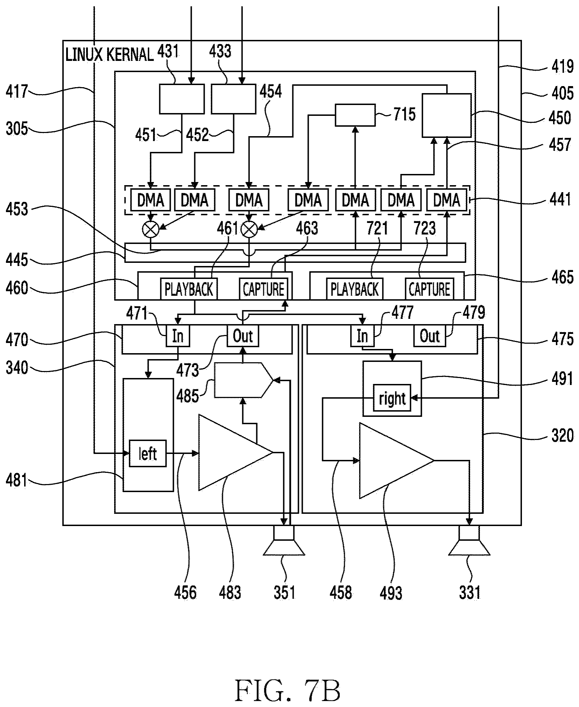

FIG. 7B is a block diagram related to audio signal processing of an electronic device according to an embodiment.

FIG. 7B may be described with reference to FIG. 1 to FIG. 4. Among the descriptions of FIG. 7B, the same description as that of FIG. 4 may not be repeated.

Compared with the DSP 305 of FIG. 4, a DSP 305 of FIG. 7B may further include a time synchronization unit 715. Compared with the DSP 305 of FIG. 4, the DSP 305 of FIG. 7B may be electrically connected to a codec 340 through an audio interface 460 and electrically connected to a codec 320 through an audio interface 465.

In an embodiment, a processor 120 (or the DSP 305) may be electrically connected to an input terminal 471 of an audio interface 470 of the codec 340 through a playback terminal 461 of the audio interface 460. In an embodiment, the processor 120 (or the DSP 305) may be electrically connected to an output terminal 473 of the audio interface 470 of the codec 340 through a capture terminal 463 of the audio interface 460.

In an embodiment, the processor 120 (or the DSP 305) may be electrically connected to an input terminal 477 of the audio interface 470 of the codec 340 through a playback terminal 721 of the audio interface 465. In an embodiment, the processor 120 (or the DSP 305) may be electrically connected to an output terminal 479 of the audio interface 470 of the codec 340 through a capture terminal 723 of the audio interface 465.

In an embodiment, in case that only one codec 340 of the codecs 320 and 340 includes a sensor 485, the processor 120 (or DSP 305) may adjust an audio signal for the codec 340 through an AMP solution 450. In an embodiment, in case that the only one codec 340 of the codecs 320 and 340 includes the sensor 485, the processor 120 (or the DSP 305) may perform reading (e.g., reading through DMAs 441) of the audio signal for the codec 320 to memory 130 (or a buffer in the processor 120 (or the DSP 305)) without processing it through the AMP solution 450. Then, in an embodiment, in case that the only one codec 340 of the codecs 320 and 340 includes the sensor 485, the processor 120 (or the DSP 305) may synchronize a timing of the read audio signal for the codec 320 with the audio signal for the codec 340 through the time synchronization unit 715, and then mix it in stereo with the audio signal for the codec 340. Herein, mixing in stereo may include processing of mixing audio signals on different channels.

In an embodiment, the time synchronization unit 715 may adjust a playback time of source audio to be transferred to the codec 320. For example, the time synchronization unit 715 may adjust the playback time of the source audio including a first audio signal and a second audio signal to be transferred to the codec 320. For example, the time synchronization unit 715 may adjust the playback time of the source audio to be transferred to the codec 320 such that the playback time of the source audio to be transferred to the codec 320 is synchronized with a playback time of source audio to be transferred to the codec 340. For example, the source audio to be transferred to the codec 320 may include an unadjusted first audio signal on a first channel and an unadjusted second audio signal on a second channel. For example, the source audio to be transferred to the codec 340 may include the adjusted first audio signal on the first channel and the unadjusted second audio signal on the second channel. However, it is not limited thereto. For example, the source audio to be transferred to the codec 340 may include the adjusted first audio signal on the first channel and the unadjusted second audio signal on the second channel.

For example, the time synchronization unit 715 may synchronize the playback time of the source audio to be transferred to the codec 320 to the playback time of the source audio to be transferred to the codec 340. In an embodiment, the time synchronization unit 715 may adjust (or delay) the playback time of the source audio to be transferred to the codec 320 based on time required to adjust the first audio signal. However, it is not limited thereto. For example, the time synchronization unit 715 may adjust (or delay) the playback time of the source audio to be transferred to the codec 320 such that a timestamp of the source audio to be transferred to the codec 320 and a timestamp of the source audio to be transferred to the codec 340 correspond to each other.

In an embodiment, the processor 120 (or the DSP 305) may transfer the source audio including the adjusted first audio signal on the first channel to the codec 340 through the audio interface 470. In an embodiment, the processor 120 (or the DSP 305) may transfer the source audio in which the playback time is delayed (or synchronized) to the codec 320 through the audio interface 475.

In an embodiment, the codec 340 may identify the adjusted first audio signal on the first channel for the first audio to be outputted through the speaker 351, from the source audio including the adjusted first audio signal on the first channel. In an embodiment, the codec 340 may transfer the adjusted first audio signal on the first channel to the speaker 351 through an AMP 483. In an embodiment, the speaker 351 may output the amplified audio signal through the AMP 483 as sound.

In an embodiment, the codec 320 may identify the second audio signal on the second channel for the second audio to be outputted through the speaker 331, from the source audio in which the playback time is delayed (or synchronized). In an embodiment, the codec 320 may transfer the second audio signal on the second channel to the speaker 331 through an AMP 493. In an embodiment, the speaker 331 may output the amplified audio signal through the AMP 493 as sound.

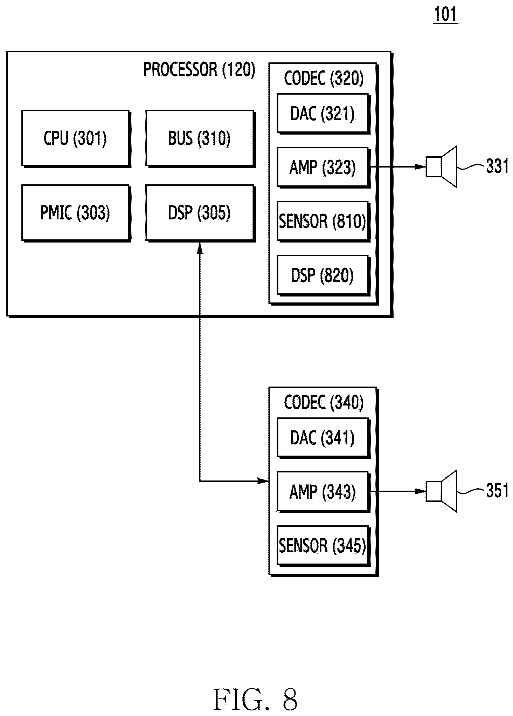

FIG. 8 is a block diagram of an electronic device according to an embodiment.

FIG. 8 may be described with reference to FIG. 1 to FIG. 4. Among the descriptions of FIG. 8, the same descriptions as those of FIG. 3 or 4 may not be repeated.

Referring to FIG. 8, an electronic device 101 may include a processor 120, a codec 340, and speakers 331 and 351. According to an embodiment, the electronic device 101 of FIG. 8 may further include the microphone 335 of FIG. 3.

In an embodiment, a codec 320 may include a DAC 321, an AMP 323, a sensor 810, and/or a DSP 820. However, components included in the codec 320 are not limited to components illustrated in FIG. 8. According to an embodiment, the codec 320 of FIG. 8 may further include the ADC 325 of FIG. 3.

In an embodiment, the sensor 810 may detect an operating state (e.g., power, voltage, and/or a current) of the codec 320 and generate data corresponding to the detected state. In an embodiment, the sensor 810 may detect intensity (or voltage, and/or a current) of an audio signal outputted through the AMP 323 and generate data corresponding to a detected state. In an embodiment, the sensor 810 may detect intensity (or voltage or a current) of an audio signal inputted to the speaker 351 and generate data corresponding to a detected state.

In an embodiment, the DSP 820 may obtain sensing data (or a sensing value) from the sensor 810. In an embodiment, the sensing data may be identified by the sensor 810 in the codec 320 in relation to output of an audio through the speaker 331. In an embodiment, the sensing data may indicate the intensity (or the voltage, and/or the current) of the audio signal outputted through the AMP 323 and/or the intensity (or the voltage, and/or the current) of the audio signal inputted to the speaker 331. However, it is not limited thereto. For example, the sensing data may indicate intensity (or voltage or a current) of the audio signal outputted through speaker 331.

In an embodiment, the DSP 820 may adjust a portion of an audio signal based on the sensing data (or the sensing value) identified through the sensor 810. In an embodiment, the DSP 820 may adjust a second audio signal on a second channel to be outputted through the speaker 331 among audio signals. In an embodiment, the DSP 820 may adjust the second audio signal on the second channel based on applying the sensing data to an unadjusted second audio signal on the second channel among an adjusted first audio signal on a first channel and the unadjusted second audio signal on the second channel included in the audio signal.

In an embodiment, the DSP 820 may adjust an output level of the unadjusted second audio signal on the second channel included in the audio signal based on the sensing value identified through the sensor 810. For example, the DSP 820 may adjust signal intensity of an audio interval having signal intensity exceeding threshold signal intensity among a plurality of audio intervals of the second audio signal based on the sensing value identified through sensor 810. For example, the DSP 820 may adjust the signal intensity of the audio interval having the signal intensity exceeding the threshold signal intensity among the plurality of audio intervals (or time intervals) of the second audio signal to less than or equal to the threshold signal intensity based on the sensing value identified through sensor 810. However, it is not limited thereto. For example, the DSP 820 may reduce the signal intensity of the second audio signal by a designated value (or by a designated ratio) based on identifying that the second audio signal at least partially exceeds the threshold signal intensity based on the sensing value identified through the sensor 810.

In an embodiment, the DSP 820 may provide an audio signal including an adjusted second audio signal on the second channel to the DAC 321. In an embodiment, the DAC 321 may convert the adjusted second audio signal on the second channel into an analog audio signal. In an embodiment, the AMP 323 may amplify the adjusted second audio signal on the second channel obtained from the DAC 321. In an embodiment, the speaker 331 may convert the second audio signal amplified by the AMP 323 into sound.

In an embodiment, the codec 340 may include a DAC 341, an AMP 343, and/or a sensor 345.

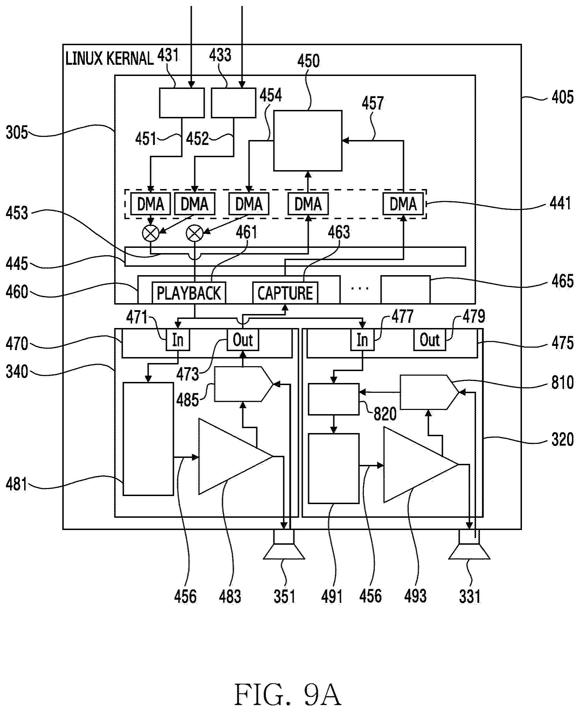

FIG. 9A is a diagram illustrating an operation in which an electronic device according to an embodiment processes an audio signal of a multi-channel.

FIG. 9A may be described with reference to FIG. 1 to FIG. 4. Among the descriptions of FIG. 9A, the same description as that of FIG. 4 may not be repeated.

Referring to FIG. 9A, a processor 120 (or a DSP 305) may identify source audio. In an embodiment, the source audio may be a stereo audio signal that includes a first audio signal on a first frequency range (or a first channel) and a second audio signal on a second frequency range (or a second channel) not overlapping the first frequency range. However, it is not limited thereto. The source audio may be a multi-channel audio signal (e.g., the stereo audio signal, or a 5.1 channel audio signal).

In an embodiment, the processor 120 (or the DSP 305) may obtain sensing data from a codec 340 through an audio interface 460. In an embodiment, the sensing data may include current data and voltage data. In an embodiment, the sensing data may include the current data in the second channel and the voltage data in the first channel. In an embodiment, the sensing data may include the current data and the voltage data of an AMP 483 and/or a speaker 351 caused by the first audio signal. In an embodiment, the sensing data may be used as reference data for an AMP solution 450 inside the DSP 305. However, it is not limited thereto. In an embodiment, the sensing data may be used as reference data for the processor 120.

In an embodiment, the processor 120 (or the DSP 305) may adjust the first audio signal on the first channel to be outputted through the speaker 351 among audio signals included in the source audio based on the sensing data. In an embodiment, the processor 120 (or the DSP 305) may not adjust the second audio signal on the second channel to be outputted through a speaker 331 among the audio signals included in the source audio.

In an embodiment, the processor 120 (or the DSP 305) may provide, to each of the codec 340 and a codec 320, an audio signal including the adjusted first audio signal on the first channel and the second audio signal on the second channel.

In an embodiment, the codec 340 may identify, from the audio signal, the adjusted first audio signal on the first channel for first audio to be outputted through the speaker 351. In an embodiment, the codec 340 may filter, from the audio signal, the second audio signal on the second channel that is not be outputted through the speaker 351. For example, the codec 340 may generate an audio signal including only the first audio signal without the second audio signal by filtering the second audio signal. In an embodiment, the speaker 351 may output the audio signal including only the first audio signal as sound.

In an embodiment, a DSP 820 of the codec 320 may obtain sensing data from a sensor 810. In an embodiment, the sensing data may include current data and voltage data. In an embodiment, the sensing data may include the current data in the second channel and the voltage data in the first channel. In an embodiment, the sensing data may include the current data and the voltage data of an AMP 493 and/or the speaker 331 caused by the first audio signal.

In an embodiment, the DSP 820 may adjust a second audio signal on the second channel to be outputted through the speaker 331 among audio signals including the adjusted first audio signal on the first channel and the second audio signal on the second channel based on sensing data. In an embodiment, the DSP 820 may not adjust the second audio signal on the second channel to be outputted through the speaker 331 among the audio signals.

In an embodiment, the DSP 820 may provide, to the DAC 321, an audio signal including the adjusted first audio signal on the first channel and the adjusted second audio signal on the second channel.

In an embodiment, the DAC 321 may identify, from the audio signal, the adjusted second audio signal on the second channel for second audio to be outputted through the speaker 331. In an embodiment, the codec 320 may filter, from the audio signal, the first audio signal on the first channel that is not be outputted through the speaker 331. For example, the codec 320 may generate an audio signal including only the adjusted second audio signal without the first audio signal by filtering the first audio signal. In an embodiment, the speaker 331 may output the audio signal including only the adjusted second audio signal as sound.

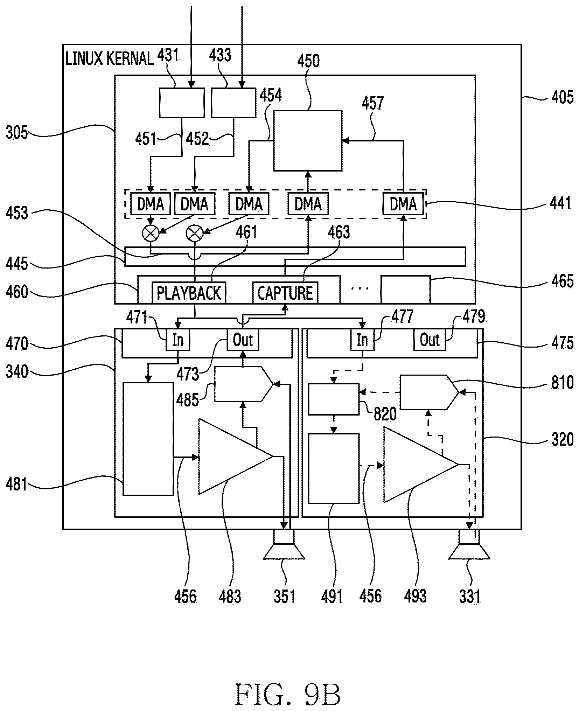

FIG. 9B is a diagram illustrating an operation in which an electronic device according to an embodiment outputs an audio signal through one speaker.

FIG. 9B may be described with reference to FIG. 1 to FIG. 4. Among the descriptions of FIG. 9B, the same description as that of FIG. 4 may not be repeated.

In an embodiment, a processor 120 (or a DSP 305) may identify source audio. In an embodiment, the processor 120 (or the DSP 305) may determine a speaker to which the source audio is to be outputted among speakers 331 and 351.

In an embodiment, the processor 120 (or the DSP 305) may determine that the source audio is outputted through the speaker 351. In an embodiment, as it is determined that the source audio is not outputted through the speaker 331, the processor 120 (or, the DSP 305) (or, the processor 120) may turn off a codec 320.

In an embodiment, the processor 120 (or the DSP 305) may obtain sensing data (or a sensing value) from a codec 340 through an audio interface 460. In an embodiment, the processor 120 (or the DSP 305) may adjust a portion of the source audio based on the sensing data (or the sensing value) identified through the sensor 485. In an embodiment, the processor 120 (or the DSP 305) may adjust a first audio signal on a first channel to be outputted through the speaker 351 among audio signals included in the source audio. In an embodiment, the source audio may not include a second audio signal on a second channel.

In an embodiment, the processor 120 (or the DSP 305) may provide, to each of the codec 340 and the codec 320, an audio signal including the adjusted first audio signal on the first channel through the audio interface 460. In an embodiment, as the codec 320 is turned off, the codec 320 may not process the audio signal including the first audio signal.

In an embodiment, the codec 340 may identify, from the audio signal, the adjusted first audio signal on the first channel for first audio to be outputted through the speaker 351. In an embodiment, the codec 340 may mix in mono the adjusted first audio signal on the first channel. For example, the codec 340 may mix in mono the adjusted first audio signal on the first channel for the first audio to be outputted through the speaker 351 based on a control signal from the processor 120 (or the DSP 305).

In an embodiment, the codec 340 may transfer the mono-mixed first audio signal on the first channel to an AMP 483. In an embodiment, the codec 340 may transfer the audio signal amplified by the AMP 483 to the speaker 351 through a signal transmission path 456 from a DAC 481 to the speaker 351. For example, the speaker 351 may output the amplified audio signal as sound.

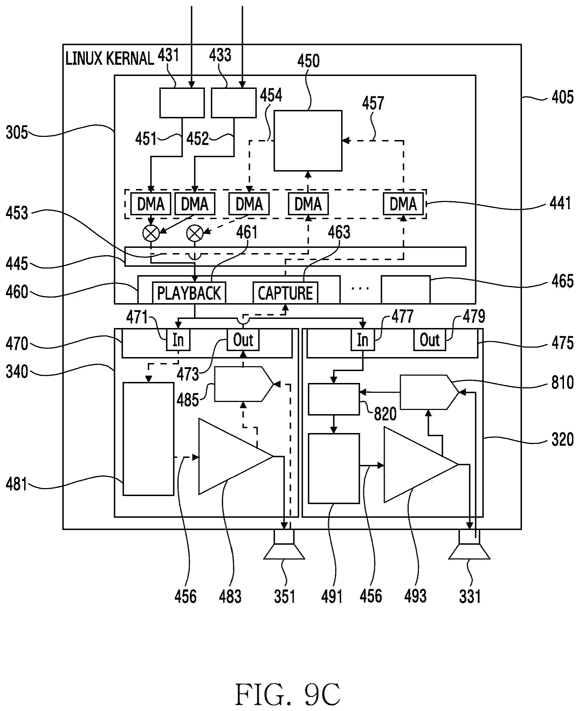

FIG. 9C is a diagram illustrating an operation in which an electronic device according to an embodiment outputs an audio signal through one speaker.

FIG. 9C may be described with reference to FIG. 1 to FIG. 4. Among the descriptions of FIG. 9C, the same description as that of FIG. 4 may not be repeated.

In an embodiment, a processor 120 (or a DSP 305) may identify source audio. In an embodiment, the processor 120 (or the DSP 305) may determine a speaker to which the source audio is to be outputted among speakers 331 and 351.

In an embodiment, the processor 120 (or the DSP 305) may determine that the source audio is outputted through the speaker 331. In an embodiment, as it is determined that the source audio is not outputted through the speaker 351, the processor 120 (or the DSP 305) (or the processor 120) may turn off the codec 340. In an embodiment, the processor 120 (or the DSP 305) (or the processor 120) may bypass an AMP solution 450. For example, bypassing the AMP solution 450 may mean that the source audio is not transferred to the AMP solution 450 but is inputted to codecs 320 and 340 through an audio interface 460.

In an embodiment, a DSP 820 of the codec 320 may obtain sensing data from a sensor 810. In an embodiment, the sensing data may include current data and voltage data. In an embodiment, the sensing data may include the current data in a second channel and the voltage data in a first channel. In an embodiment, the sensing data may include the current data and the voltage data of an AMP 493 and/or the speaker 331 caused by the first audio signal.

In an embodiment, the DSP 820 may adjust a second audio signal on a second channel to be outputted through the speaker 331 among audio signals including the first audio signal on the first channel and the second audio signal on the second channel based on sensing data. In an embodiment, the DSP 820 may not adjust the second audio signal on the second channel to be outputted through the speaker 331 among the audio signals.

In an embodiment, the DSP 820 may provide, to a DAC 491, an audio signal including the first audio signal on the first channel and the adjusted second audio signal on the second channel.

In an embodiment, the DAC 491 may identify, from the audio signal, the adjusted second audio signal on the second channel for second audio to be outputted through the speaker 331. In an embodiment, the codec 320 may filter, from the audio signal, the first audio signal on the first channel that is not be outputted through the speaker 331. For example, the codec 320 may generate an audio signal including only the adjusted second audio signal without the first audio signal by filtering the first audio signal. In an embodiment, the speaker 331 may output the audio signal including only the adjusted second audio signal as sound.

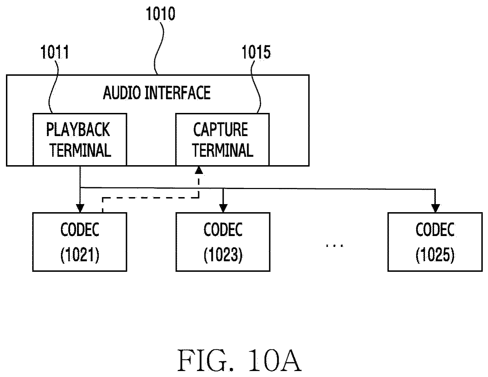

FIG. 10A is a diagram illustrating a structure between an audio interface and codecs, included in an electronic device according to an embodiment.

In FIG. 3, FIG. 4, FIG. 5A, FIG. 6A, FIG. 6B, FIG. 7A, FIG. 7B, FIG. 8, FIG. 9A, FIG. 9B, and FIG. 9C, it is illustrated that the codecs 320 and 340 are two. However, this is only an example. Referring to FIG. 10A, three or more codecs 1021, 1023, and 1025 may be electrically connected to one audio interface 1010.

The audio interface 1010 of FIG. 10A and the three or more codecs 1021, 1023, and 1025 may replace the audio interface 460 and the codecs 320 and 340 of FIG. 3, FIG. 4, FIG. 5A, FIG. 6A, FIG. 6B, FIG. 7A, FIG. 7B, FIG. 8, FIG. 9A, FIG. 9B, and FIG. 9C.

For example, the audio interface 1010 may be electrically connected to the codecs 1021, 1023, and 1025 through a playback terminal 1011. For example, the audio interface 1010 may be electrically connected to the codec 1021 among the codecs 1021, 1023, and 1025 through a capture terminal 1015.

In an embodiment, the codecs 1021, 1023, and 1025 may simultaneously (or equally) obtain three or more audio signals included in each of three or more channels through the audio interface 1010.

In an embodiment, the codecs 1021, 1023, and 1025 may obtain (or identify) an audio signal of a channel assigned to themselves among the three or more audio signals based on a control signal of a processor 120 (or a DSP 305). In an embodiment, the codecs 1021, 1023, and 1025 may output the audio signal of the channel assigned to themselves through a speaker electrically connected to themselves. In an embodiment, an output level of the three or more audio signals may be restricted or not be restricted according to performance and/or a component of the codecs 1021, 1023, and 1025.

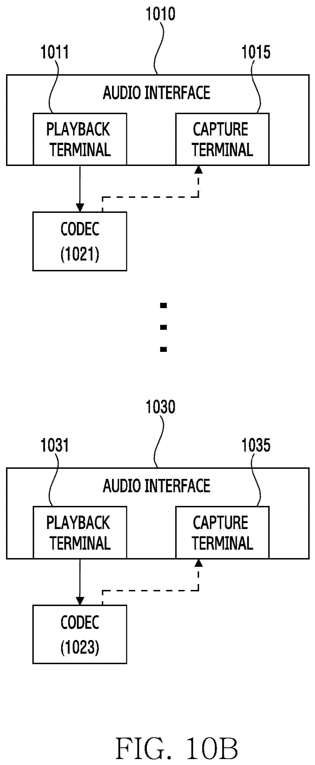

FIG. 10B is a diagram illustrating a structure between an audio interface and codecs, included in an electronic device according to an embodiment.

In FIG. 3, FIG. 4, FIG. 5A, FIG. 6A, FIG. 6B, FIG. 7A, FIG. 8, 9A, 9B, and 9C, it is illustrated that the codecs 320 and 340 are electrically connected to one audio interface 360. However, this is only an example. Referring to FIG. 10B, codecs 1021 and 1023 may be electrically connected to two or more audio interfaces 1010 and 1030, respectively.

The two or more audio interfaces 1010 and 1030 and the codecs 1021 and 1023 of FIG. 10B may replace the audio interfaces 460 and 465 and the codecs 320 and 340 of FIG. 3, FIG. 4, FIG. 5A, FIG. 6A, FIG. 6B, FIG. 7A, FIG. 7B, FIG. 8, FIG. 9A, FIG. 9B, and FIG. 9C.

For example, the audio interface 1010 may be electrically connected to the codec 1021 through a playback terminal 1011. For example, the audio interface 1010 may be electrically connected to the codec 1021 through a capture terminal 1015.

For example, the audio interface 1030 may be electrically connected to the codec 1023 through a playback terminal 1031. For example, the audio interface 1030 may be electrically connected to the codec 1023 through a capture terminal 1035.

In an embodiment, the codecs 1021 and 1023 may respectively obtain two or more audio signals included in each of the two or more channels through the audio interfaces 1010 and 1030. In an embodiment, an audio signal transferred to the codecs 1021 and 1023 may be the same. However, it is not limited thereto. In an embodiment, the audio signal transferred to the codecs 1021 and 1023 may be different from each other.

In an embodiment, the codecs 1021 and 1023 may obtain (or identify) an audio signal of a channel assigned to themselves among the two or more audio signals based on a control signal of a processor 120 (or a DSP 305). In an embodiment, the codecs 1021 and 1023 may output the audio signal of the channel assigned to themselves through a speaker electrically connected to themselves. In an embodiment, an output level of the two or more audio signals may be restricted or may not be restricted according to performance and/or a component of the codecs 1021 and 1023.

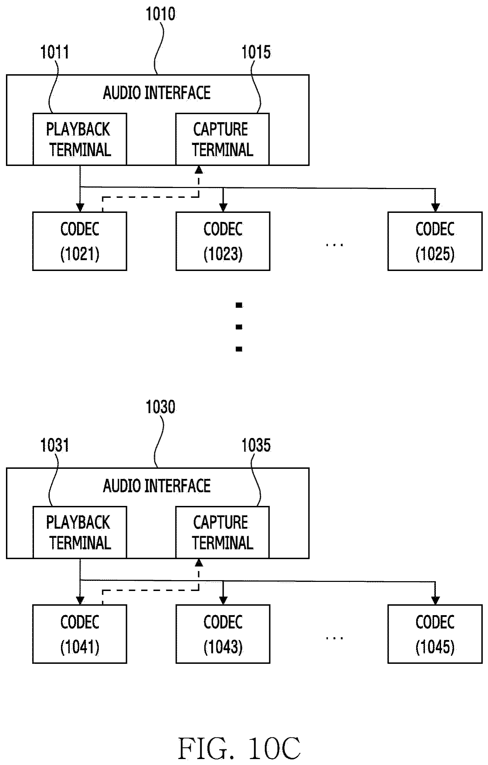

FIG. 10C is a diagram illustrating a structure between an audio interface and codecs, included in an electronic device according to an embodiment.

FIG. 10C may illustrate a complex situation of FIG. 10A and FIG. 10B. Audio interfaces 1010 and 1030 and codecs 1021, 1023, 1025, 1041, 1043, and 1045 of FIG. 10A may replace the audio interfaces 460 and 465 and the codecs 320 and 340 of FIG. 3, FIG. 4, FIG. 5A, FIG. 6A, FIG. 6B, FIG. 7A, FIG. 7B, FIG. 8, FIG. 9A, FIG. 9B, and FIG. 9C.

For example, the audio interface 1010 may be electrically connected to the codecs 1021, 1023, and 1025 through a playback terminal 1011. For example, the audio interface 1010 may be electrically connected to the codec 1021 among the codecs 1021, 1023, and 1025 through a capture terminal 1015. For example, the audio interface 1030 may be electrically connected to the codecs 1041, 1043, and 1045 through a playback terminal 1031. For example, the audio interface 1030 may be electrically connected to the codec 1041 among the codecs 1041, 1043, and 1045 through a capture terminal 1035.

In an embodiment, the codecs 1021, 1023, and 1025 may simultaneously (or equally) obtain three or more audio signals included in each of three or more channels through the audio interface 1010. In an embodiment, the codecs 1041, 1043, and 1045 may simultaneously (or equally) obtain three or more audio signals included in each of three or more channels through the audio interface 1030. In an embodiment, the audio signal transferred to the codecs 1021, 1023, and 1025 may be the same as an audio signal transferred to the codecs 1041, 1043, and 1045. However, it is not limited thereto. In an embodiment, the audio signal transferred to the codecs 1021, 1023, and 1025 and the audio signal transferred to the codecs 1041, 1043, and 1045 may be different from each other.

In an embodiment, the codecs 1021, 1023, 1025, 1041, 1043, and 1045 may obtain (or identify) an audio signal of a channel assigned to themselves among the audio signals based on a control signal of a processor 120 (or a DSP 305). In an embodiment, the codecs 1021, 1023, 1025, 1041, 1043, and 1045 may output the audio signal of the channel assigned to themselves through a speaker electrically connected to themselves. In an embodiment, an output level of the audio signals may be restricted or may not be restricted according to performance and/or a component of the codecs 1021, 1023, 1025, 1041, 1043, and 1045.

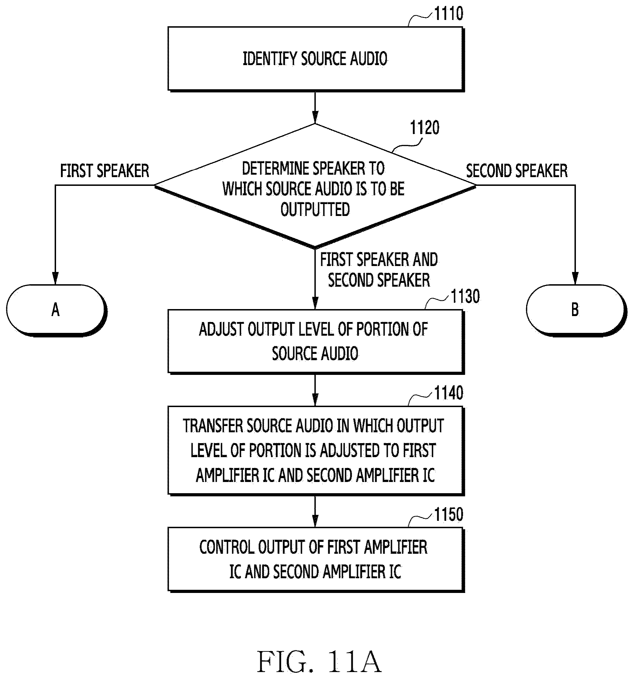

FIG. 11A to FIG. 11C are flowcharts illustrating an operation of an electronic device according to an embodiment.

FIG. 11A to FIG. 11C may be described with reference to FIG. 1 to FIG. 10C. Operations of FIG. 11A to FIG. 11C may be performed by an electronic device 101 based on a processor 120 (or a DSP 305) executing instructions stored in memory 130.

Referring to FIG. 11A, in operation 1110, the electronic device 101 may identify source audio. In an embodiment, the electronic device 101 may identify audio signals generated through an application (e.g., the 411 of FIG. 4) as the source audio. In an embodiment, the source audio may be a multi-channel audio signal (e.g., a stereo audio signal, or a 5.1 channel audio signal) that includes different audio signals on different frequency ranges. For example, the source audio may be a stereo audio signal that includes a first audio signal on a first frequency range (or a first channel) and a second audio signal on a second frequency range (or a second channel) not overlapping the first frequency range.

In operation 1120, the electronic device 101 may determine a speaker to which the source audio is to be outputted. In an embodiment, the electronic device 101 may determine the speaker to which the source audio is to be outputted among speakers 331 and 351 based on a characteristic (a mono or multi-channel audio signal) of the source audio. In an embodiment, the electronic device 101 may determine the speaker to which the source audio is to be outputted among the speakers 331 and 351 based on information included in an output request of the source audio of the application.

In an embodiment, the electronic device 101 may perform operation 1130 based on determining that the source audio is outputted through the speaker 351 and the speaker 331.

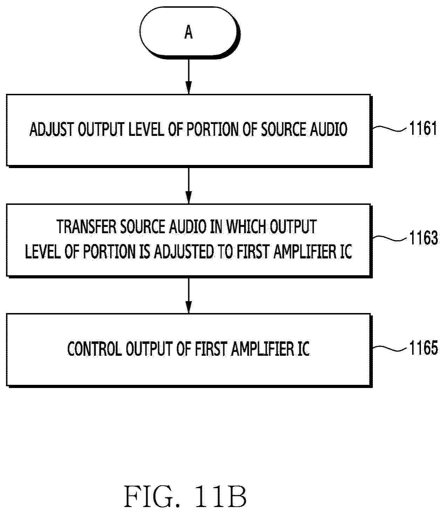

In an embodiment, the electronic device 101 may perform operation 1161 of FIG. 11B connected through a connector A based on determining that the source audio is outputted through the speaker 351.

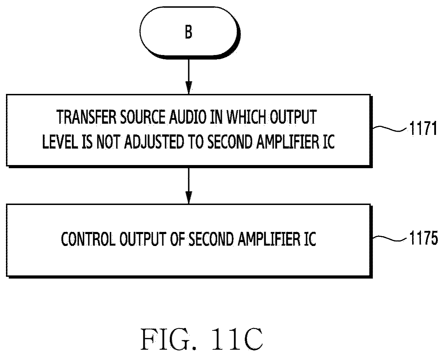

In an embodiment, the electronic device 101 may perform operation 1171 of FIG. 11C connected through a connector B based on determining that the source audio is outputted through the speaker 331.

In the operation 1130, the electronic device 101 may adjust an output level of a portion of the source audio. In an embodiment, the electronic device 101 may adjust the output level (or intensity) of the portion of the source audio based on sensing data (or a sensing value) identified through a sensor 485.

In an embodiment, the electronic device 101 may adjust the first audio signal on the first channel to be outputted through the speaker 351 among audio signals included in the source audio. In an embodiment, the electronic device 101 may adjust the first audio signal on the first channel based on applying the sensing data to the first audio signal on the first channel among the first audio signal on the first channel and the second audio signal on the second channel included in the source audio. In an embodiment, the electronic device 101 may not adjust the second audio signal on the second channel to be outputted through the speaker 331 among the audio signals included in the source audio.

In operation 1140, the electronic device 101 may transfer the source audio in which the output level of the portion is adjusted to a first amplifier IC (or a codec 340) and a second amplifier IC (or a codec 320). In an embodiment, the electronic device 101 may provide, to each of the first amplifier IC (or the codec 340) and the second amplifier IC (or the codec 320), an audio signal including the adjusted first audio signal on the first channel and the second audio signal on the second channel through an audio interface 460. In an embodiment, the electronic device 101 may simultaneously transfer the audio signal to the first amplifier IC (or the codec 340) and the second amplifier IC (or the codec 320) through a playback terminal 461 of the audio interface 460.

In operation 1150, the electronic device 101 may control output of the first amplifier IC (or the codec 340) and the second amplifier IC (or the codec 320). The electronic device 101 may control the output of the first amplifier IC (or the codec 340) and the second amplifier IC (or the codec 320) through control signals 417 and 419.

In an embodiment, the electronic device 101 may control the first amplifier IC (or the codec 340), such that the first amplifier IC (or the codec 340) identifies the adjusted first audio signal on the first channel for first audio to be outputted through the speaker 351 from the audio signal.

In an embodiment, the electronic device 101 may control the first amplifier IC (or the codec 340), such that the first amplifier IC (or the codec 340) amplifies the adjusted first audio signal on the first channel and then transfers the amplified audio signal to the speaker 351. For example, the speaker 351 may output the amplified audio signal as sound.

In an embodiment, the electronic device 101 may control the second amplifier IC (or the codec 320) such that the second amplifier IC (or the codec 320) identifies the second audio signal on the second channel for second audio to be outputted through the speaker 331 from the audio signal.

In an embodiment, the electronic device 101 may control the second amplifier IC (or the codec 320) such that the second amplifier IC (or the codec 320) amplifies the second audio signal on the second channel and then transfers the amplified audio signal to the speaker 331. For example, the speaker 331 may output the amplified audio signal as sound.

Referring to FIG. 11B, in the operation 1161, the electronic device 101 may adjust the output level of the portion of the source audio.

In an embodiment, the electronic device 101 may adjust the output level (or the intensity) of the portion of the source audio based on the sensing data (or the sensing value) identified through the sensor 485. In an embodiment, the electronic device 101 may adjust the first audio signal on the first channel to be outputted through the speaker 351 among the audio signals included in the source audio. In an embodiment, the electronic device 101 may adjust the first audio signal on the first channel based on applying the sensing data to the first audio signal on the first channel included in the source audio.

In operation 1163, the electronic device 101 may transfer the source audio in which the output level of the portion is adjusted to the first amplifier IC (or the codec 340). In an embodiment, as it is determined that the source audio is not outputted through the speaker 331, the electronic device 101 may turn off the codec 320. In an embodiment, as the codec 320 is turned off, the codec 320 may not process the source audio in which the output level of the portion is adjusted.

In operation 1165, the electronic device 101 may control the output of the first amplifier IC (or the codec 340).

In an embodiment, the electronic device 101 may control the first amplifier IC (or the codec 340), such that the first amplifier IC (or the codec 340) identifies the adjusted first audio signal on the first channel for the first audio to be outputted through the speaker 351 from the audio signal. In an embodiment, the electronic device 101 may control the first amplifier IC (or the codec 340) such that the first amplifier IC (or the codec 340) mixes in mono the adjusted first audio signal on the first channel.

In an embodiment, the electronic device 101 may control the first amplifier IC (or the codec 340) such that the first amplifier IC (or the codec 340) amplifies the mono-mixed first audio signal and then transfers the amplified audio signal to the speaker 351. For example, the speaker 351 may output the amplified audio signal as sound.

Referring to FIG. 11C, in the operation 1171, the electronic device 101 may transfer the source audio in which the output level is not adjusted to the second amplifier IC (or the codec 320).

In an embodiment, as it is determined that the source audio is not outputted through the speaker 351, the electronic device 101 may bypass an AMP solution 450. For example, bypassing the AMP solution 450 may mean that the source audio is not transferred to the AMP solution 450 but is inputted to the codecs 320 and 340 through the audio interface 460. In an embodiment, as it is determined that the source audio is not outputted through the speaker 351, the electronic device 101 may turn off the codec 340. In an embodiment, as the codec 340 is turned off, the codec 340 may not process the source audio in which the output level is not adjusted.

In operation 1175, the electronic device 101 may control the output of the second amplifier IC (or the codec 320).

In an embodiment, the electronic device 101 may control the second amplifier IC (or the codec 320), such that the second amplifier IC (or the codec 320) identifies the second audio signal on the second channel for the second audio to be outputted through the speaker 331 from the audio signal. In an embodiment, the electronic device 101 may control the second amplifier IC (or the codec 320), such that the second amplifier IC (or codec 320) mixes in mono the second audio signal on the second channel.

In an embodiment, the electronic device 101 may control the second amplifier IC (or the codec 320) such that the second amplifier IC (or the codec 320) amplifies the mono-mixed second audio signal and then transfers the amplified audio signal to the speaker 331. For example, the speaker 331 may output the amplified audio signal as sound.

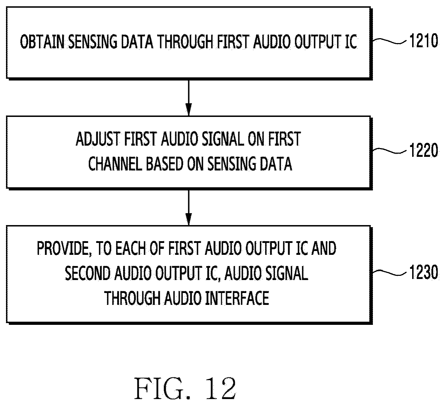

FIG. 12 is a flowchart illustrating an operation of an electronic device according to an embodiment.

FIG. 12 may be described with reference to FIG. 1 to FIG. 10C. Operations of FIG. 12 may be performed by an electronic device 101 based on a processor 120 (or a DSP 305) executing instructions stored in memory 130.

Referring to FIG. 12, in operation 1210, the electronic device 101 may obtain sensing data through a first audio output IC (e.g., a codec 340). For example, the electronic device 101 may obtain the sensing data obtained by the sensor 485 through an audio interface 460. In an embodiment, the sensing data may indicate intensity (or voltage, and/or a current) of an audio signal outputted through the first audio output IC (e.g., the codec 340) and/or intensity (or voltage, and/or a current) of an audio signal inputted to a speaker 351.

In operation 1220, the electronic device 101 may adjust a first audio signal on a first channel based on the sensing data. In an embodiment, the electronic device 101 may adjust the first audio signal on the first channel to be outputted through the speaker 351 among audio signals included in source audio. In an embodiment, the electronic device 101 may adjust the first audio signal on the first channel based on applying the sensing data to the first audio signal on the first channel among the first audio signal on the first channel and a second audio signal on a second channel included in the source audio.

In operation 1230, the electronic device 101 may provide, to each of the first audio output IC (or the codec 340) and a second audio output IC (or a codec 320), an audio signal through the audio interface 460. In an embodiment, the electronic device 101 may simultaneously transfer the audio signal to the first audio output IC (or the codec 340) and the second audio output IC (or the codec 320) through a playback terminal 461 of the audio interface 460 included in the processor 120 (or the DSP 305).

As described above, an electronic device 101 may comprise a first audio output integrated circuit (IC) 340 including IV (current and voltage) sensing circuitry 345, a first speaker 351 connected to the first audio output IC 340, a second audio output IC 320, a second speaker 331 connected to the second audio output IC 320, processing circuitry 120 including an audio interface 460 connected to each of the first audio output IC 340 and the second audio output IC 320, and memory 130, comprising one or more storage mediums, storing instructions. The instructions may be configured to, when executed by the processing circuitry 120 individually or collectively, cause the electronic device 101 to obtain, from the first audio output IC 340 via the audio interface 460, sensing data 520 identified by the IV sensing circuitry 345 in the first audio output IC 340, in relation to output of an audio via the first speaker 351. The instructions may be configured to, when executed by the processing circuitry 120 individually or collectively, cause the electronic device 101 to adjust a first audio signal 515 on a first channel, based on applying the sensing data 520 to source audio 510. The instructions may be configured to, when executed by the processing circuitry 120 individually or collectively, cause the electronic device 101 to provide, to each of the first audio output IC 340 and the second audio output IC 320 via the audio interface 460, an audio signal 530 including the adjusted first audio signal 535 on the first channel and a second audio signal 531 on a second channel. The applying the sensing data 520 to the source audio 510 may comprise applying the sensing data 520 to the first audio signal 515 on the first channel among the first audio signal 515 on the first channel and a second audio signal 511 on the second channel included in the source audio 510. In an embodiment, the processing circuit 120 may include a DSP 305.

The audio interface 460 may include a single terminal 461 electrically connected to the first audio output IC 340 and the second audio output IC 320. The instructions may be configured to, when executed by the processing circuitry 120 individually or collectively, cause the electronic device 101 to provide, to each of the first audio output IC 340 and the second audio output IC 320 at the same time via the single terminal 461, the audio signal 530.

The second audio output IC 320 may include another IV sensing circuitry 810 for obtaining another sensing data, and a digital signal processor (DSP) 820 for adjusting the second audio signal 511 on the second channel, based on applying, to the second audio signal 511 on the second channel, the another sensing data identified by the another IV sensing circuitry 810 in the second audio output IC 320, in relation to output of an audio via the second speaker 331.

The instructions may be configured to, when executed by the processing circuitry 120 individually or collectively, cause the electronic device 101 to control the first audio output IC 340 to identify, from the audio signal 530, the adjusted first audio signal 535 on the first channel for a first audio to be outputted via the first speaker 351. The instructions may be configured to, when executed by the processing circuitry 120 individually or collectively, cause the electronic device 101 to control the second audio output IC 320 to identify, from the audio signal 530, the second audio signal 531 on the second channel for a second audio to be outputted via the second speaker 331.

The instructions may be configured to, when executed by the processing circuitry 120 individually or collectively, cause the electronic device 101 to, based on that the source audio 510 is determined to be outputted via the first speaker 351 among the first speaker 351 and the second speaker 331, turn off the second audio output IC 320, adjust the first audio signal 515 on the first channel, based on the sensing data 520, and provide, to the first audio output IC 340 via the audio interface 460, the audio signal including only the adjusted first audio signal 535 on the first channel.

The instructions may be configured to, when executed by the processing circuitry 120 individually or collectively, cause the electronic device 101 to control the first audio output IC 340 to mix in mono, from the audio signal, the adjusted first audio signal 535 on the first channel for a first audio to be outputted via the first speaker 351.

The instructions may be configured to, when executed by the processing circuitry 120 individually or collectively, cause the electronic device 101 to, based on that the source audio 510 is determined to be outputted via the second speaker 331 among the first speaker 351 and the second speaker 331, turn off the first audio output IC 340, and provide, to the second audio output IC 320 via the audio interface 460, the audio signal including only the second audio signal 511 on the second channel.

The source audio 510 may be a stereo audio signal including the first audio signal 515 on a first frequency range and the second audio signal 511 on a second frequency range not overlapping the first frequency range.

The instructions may be configured to, when executed by the processing circuitry 120 individually or collectively, cause the electronic device 101 to adjust a playback time of the second audio signal 511 of the source audio 510 based on time required to adjust the first audio signal 515 of the source audio 510, such that the second audio signal 511 and the first audio signal 515 are synchronized each other.

The audio interface 460 may include a playback terminal 461 electrically connected to an input terminal 471 of the first audio output IC 340 and an input terminal 477 of the second audio output IC 320, and a capture terminal 463 electrically connected to an output terminal 473 of the first audio output IC 340 among the first audio output IC 340 and the second audio output IC 320, and for receiving the sensing data 520 of the IV sensing circuitry 345.

The audio interface 460 may include a first audio interface 460 for electrically connecting the first audio output IC 340 and the processing circuitry 120, and a second audio interface 465 for electrically connecting the second audio output IC 320 and the processing circuitry 120.

The instructions may be configured to, when executed by the processing circuitry 120 individually or collectively, cause the electronic device 101 to provide, to the first audio output IC 340 via the first audio interface 460, the adjusted first audio signal 535 of the audio signal 530. The instructions may be configured to, when executed by the processing circuitry 120 individually or collectively, cause the electronic device 101 to provide, to the second audio output IC 320 via the second audio interface 465, the second audio signal 531 of the audio signal 530.

The instructions may be configured to, when executed by the processing circuitry 120 individually or collectively, cause the electronic device 101 to adjust signal intensity of an audio interval 583 having signal intensity exceeding threshold signal intensity 571 or 575 among a plurality of audio intervals 581 and 583 of the first audio signal 515, based on the sensing data 520.

As described above, a method may be performed by an electronic device 101 comprising a first audio output integrated circuit (IC) 340 including IV (current and voltage) sensing circuitry 345, a first speaker 351 connected to the first audio output IC 340, a second audio output IC 320, a second speaker 331 connected to the second audio output IC 320, and processing circuitry 120 including an audio interface 460 connected to each of the first audio output IC 340 and the second audio output IC 320. The method may comprise obtaining, from the first audio output IC 340 via the audio interface 460, sensing data 520 identified by the IV sensing circuitry 345 in the first audio output IC 340, in relation to output of an audio via the first speaker 351. The method may comprise adjusting a first audio signal 515 on a first channel, based on applying the sensing data 520 to source audio 510. The method may comprise providing, to each of the first audio output IC 340 and the second audio output IC 320 via the audio interface 460, an audio signal 530 including the adjusted first audio signal 535 on the first channel and a second audio signal 531 on a second channel. The applying the sensing data 520 to the source audio 510 may comprise applying the sensing data 520 to the first audio signal 515 on the first channel between the first audio signal 515 on the first channel and a second audio signal 511 on the second channel included in the source audio 510.

The audio interface 460 may include a single terminal 461 electrically connected to the first audio output IC 340 and the second audio output IC 320. The method may comprise providing, to each of the first audio output IC 340 and the second audio output IC 320 at the same time via the single terminal 461, the audio signal 530.

The method may comprise, based on that the source audio 510 is determined to be outputted via the first speaker 351 among the first speaker 351 and the second speaker 331, turning off the second audio output IC 320, adjusting the first audio signal 515 on the first channel, based on the sensing data 520, and providing, to the first audio output IC 340 via the audio interface 460, the audio signal including only the adjusted first audio signal 535 on the first channel.

The method may comprise, based on that the source audio 510 is determined to be outputted via the second speaker 331 among the first speaker 351 and the second speaker 331, turning off the first audio output IC 340, and providing, to the second audio output IC 320 via the audio interface 460, the audio signal including only the second audio signal 511 on the second channel.

The method may comprise adjusting a playback time of the second audio signal 511 of the source audio 510 based on time required to adjust the first audio signal 515 of the source audio 510, such that the second audio signal 511 and the first audio signal 515 are synchronized each other.

The method may comprise adjusting signal intensity of an audio interval 583 having signal intensity exceeding threshold signal intensity 571 or 575 among a plurality of audio intervals 581 and 583 of the first audio signal 515, based on the sensing data 520.

As described above, a non-transitory computer readable storage medium may comprise one or more programs including instructions. The instructions may be configured, when executed by processing circuitry 120 of an electronic device 101 comprising a first audio output integrated circuit (IC) 340 including IV (current and voltage) sensing circuitry 345, a first speaker 351 connected to the first audio output IC 340, a second audio output IC 320, a second speaker 331 connected to the second audio output IC 320, and the processing circuitry 120 including an audio interface 460 connected to each of the first audio output IC 340 and the second audio output IC 320, individually or collectively, to cause the electronic device 101 to obtain, from the first audio output IC 340 via the audio interface 460 , sensing data 520 identified by the IV sensing circuitry 345 in the first audio output IC 340, in relation to output of an audio via the first speaker 351. The instructions may be configured, when executed by the processing circuitry 120 individually or collectively, to cause the electronic device 101 to adjust a first audio signal 515 on a first channel, based on applying the sensing data 520 to source audio 510. The instructions may be configured, when executed by the processing circuitry 120 individually or collectively, to cause the electronic device 101 to provide, to each of the first audio output IC 340 and the second audio output IC 320 via the audio interface 460, an audio signal 530 including the adjusted first audio signal 535 on the first channel and a second audio signal 531 on a second channel. The applying the sensing data 520 to the source audio 510 may comprise applying the sensing data 520 to the first audio signal 515 on the first channel between the first audio signal 515 on the first channel and a second audio signal 511 on the second channel included in the source audio 510.

As described above, an electronic device 101 may comprise a first amplifier IC 340 that includes IV (current and voltage) sensing circuitry 345 identifying voltage and/or a current of a first audio signal 545 outputted through the first amplifier integrated circuitry (IC) 340, a first speaker 351, connected to the first amplifier IC 340, converting the first audio signal 515 into sound, a second amplifier IC 320 outputting a second audio signal 511, a second speaker 331, connected to the second amplifier IC 320, converting the second audio signal 511 into sound, processing circuitry 120, including an audio interface 460 electrically connected to the first amplifier IC 340 and the second amplifier IC 320, generating an audio signal to be inputted to the first amplifier IC 340 and the second amplifier IC 320 through the audio interface 460, and memory 130, storing instructions, comprising one or more storage mediums. The instructions may be configured to, when executed by the processing circuitry 120 individually or collectively, cause the electronic device 101 to identify source audio 510. The instructions may be configured to, when executed by the processing circuitry 120 individually or collectively, cause the electronic device 101 to determine a speaker to which the source audio 510 is to be outputted. The instructions may be configured to, when executed by the processing circuitry 120 individually or collectively, cause the electronic device 101 to, based on that the source audio 510 is determined to be outputted via the first speaker 351 and the second speaker 331, based on sensing value 520 identified via the IV sensing circuitry 345, adjust an output level of a portion 525 of the source audio 510. The instructions may be configured to, when executed by the processing circuitry 120 individually or collectively, cause the electronic device 101 to, based on that the source audio 510 is determined to be outputted via the first speaker 351 and the second speaker 331, transfer the source audio 530 in which the output level of the portion 525 is adjusted, to the first amplifier IC 340 and the second amplifier IC 320 via the audio interface 460. The instructions may be configured to, when executed by the processing circuitry 120 individually or collectively, cause the electronic device 101 to, based on that the source audio 510 is determined to be outputted via the first speaker 351 and the second speaker 331, control the first amplifier IC 340, such that the first amplifier IC 340 outputs the first audio signal 545 corresponding to the portion 535 in which the output level of the source audio 530 is adjusted, via the first speaker 251. The instructions may be configured to, when executed by the processing circuitry 120 individually or collectively, cause the electronic device 101 to, based on that the source audio 510 is determined to be outputted via the first speaker 351 and the second speaker 331, control the second amplifier IC 320, such that the second amplifier IC 320 outputs the second audio signal 561 corresponding to another portion 531 in which the output level of the source audio 510 is not adjusted, via the second speaker 331.

The audio interface 460 may include a single terminal 461 electrically connected to the first amplifier IC 340 and the second amplifier IC 320. The instructions may be configured to, when executed by the processing circuitry 120 individually or collectively, cause the electronic device 101 to transfer, to each of the first amplifier IC 340 and the second amplifier IC 320 at the same time via the single terminal 461, the audio signal 530 in which the output level of the portion 515 is adjusted.

The second amplifier IC 320 may include another IV sensing circuitry 810 for identifying voltage and/or a current of the second audio signal 561 outputted via the second amplifier IC 320, and a digital signal processor (DSP) 820 for adjusting the output level of the another portion 531 of the source audio 530 to be outputted via the second speaker 331 based on another sensing value identified via the another IV sensing circuitry 810.

The instructions may be configured to, when executed by the processing circuitry 120 individually or collectively, cause the electronic device 101 to, based on that the source audio 510 is determined to be outputted via the first speaker 351, turn off the second amplifier IC 320, adjust the output level of the source audio 510 based on the sensing value 520 identified via the IV sensing circuitry 345, transfer the source audio 530 in which the output level is adjusted to the first amplifier IC 340 via the audio interface 460, and control the first amplifier IC 340 for the first amplifier IC to output the first audio signal 545 corresponding to the source audio 530 in which the output level is adjusted via the first speaker 351.

The instructions may be configured to, when executed by the processing circuitry 120 individually or collectively, cause the electronic device 101 to control the first amplifier IC 340, such that the first amplifier IC 340 generates the first audio signal 545 by mixing in mono the source audio 530 in which the output level is adjusted.

The instructions may be configured to, when executed by the processing circuitry 120 individually or collectively, cause the electronic device 101 to, based on that the source audio 510 is determined to be outputted via the second speaker 331, turn off the first amplifier IC 340, transfer the second audio signal 531 based on the source audio 510 in which the output level is not adjusted to the second amplifier IC 320, and control the second amplifier IC 320 for the second amplifier IC 320 to output the second audio signal 561 corresponding to the source audio 510 in which the output level is not adjusted, via the second speaker 331.

The source audio 510 may be a multi-channel audio signal including the portion 515 on a first frequency range and the another portion 511 on a second frequency range not overlapping the first frequency range.

The instructions may be configured to, when executed by the processing circuitry 120 individually or collectively, cause the electronic device 101 to adjust a playback time of the another portion 531 of the source audio 530 based on time required to adjust the output level of the portion 535 of the source audio 530, such that the second audio signal 561 and the first audio signal 545 are synchronized each other.

The audio interface 460 may include a playback terminal 461 electrically connected to an input terminal 471 of the first amplifier IC 340 and an input terminal 477 of the second amplifier IC 320, and a capture terminal 463 for receiving the sensing value 520 of the IV sensing circuitry 345, electrically connected to an output terminal 473 of the first amplifier IC 340 among the first amplifier IC 340 and the second amplifier 320.

The audio interface 460 may include a first audio interface 460 for electrically connecting the first amplifier IC 340 and the processing circuitry 120, and a second audio interface 465 for electrically connecting the second amplifier IC 320 and the processing circuitry 120.

The instructions may be configured to, when executed by the processing circuitry 120 individually or collectively, cause the electronic device 101 to transfer the portion 535 in which the output level of the source audio 530 is adjusted to the first amplifier IC 340 via the first audio interface 460. The instructions may be configured to, when executed by the processing circuitry 120 individually or collectively, cause the electronic device 101 to transfer the another portion 531 of the source audio 530 to the second amplifier IC 320 via the second audio interface 465.

The instructions may be configured to, when executed by the processing circuitry 120 individually or collectively, cause the electronic device 101 to adjust an output level of an audio interval 583 having an output level exceeding a threshold level 571 or 575 among a plurality of audio intervals 581 and 583 of the portion 515, based on the sensing value 520.

As described above, a method may be performed by an electronic device 101 comprising a first amplifier IC 340 including IV (current and voltage) sensing circuitry 345 identifying voltage and/or a current of a first audio signal 545 outputted through the first amplifier integrated circuitry (IC) 340, a first speaker 351, connected to the first amplifier IC 340, converting the first audio signal 515 into sound, a second amplifier IC 320 outputting a second audio signal 511, a second speaker 331, connected to the second amplifier IC 320, converting the second audio signal 511 into sound, and processing circuitry 120, including an audio interface 460 electrically connected to the first amplifier IC 340 and the second amplifier IC 320, generating an audio signal to be inputted to the first amplifier IC 340 and the second amplifier IC 320 via the audio interface 460. The method may comprise identifying source audio 510. The method may comprise determining a speaker to which the source audio 510 is to be outputted. The method may comprise, based on that the source audio 510 is determined to be outputted via the first speaker 351 and the second speaker 331, based on a sensing value 520 identified via the IV sensing circuitry 345, adjusting an output level of a portion 525 of the source audio 510. The method may comprise, based on that the source audio 510 is determined to be outputted via the first speaker 351 and the second speaker 331, transferring the source audio 530 in which the output level of the portion 525 is adjusted, to the first amplifier IC 340 and the second amplifier IC 320 via the audio interface 460. The method may comprise, based on that the source audio 510 is determined to be outputted via the first speaker 351 and the second speaker 331, controlling the first amplifier IC 340, such that the first amplifier IC 340 outputs the first audio signal 545 corresponding to the portion 535 in which the output level of the source audio 530 is adjusted, via the first speaker 251. The method may comprise, based on that the source audio 510 is determined to be outputted via the first speaker 351 and the second speaker 331, controlling the second amplifier IC 320, such that the second amplifier IC 320 outputs the second audio signal 561 corresponding to another portion 531 in which the output level of the source audio 510 is not adjusted, via the second speaker 331.

The audio interface 460 may include a single terminal 361 electrically connected to the first amplifier IC 340 and the second amplifier IC 320. The method may comprise transferring to each of the first amplifier IC 340 and the second amplifier IC 320 at the same time via the single terminal 361, the audio signal 530 in which the output level of the portion 515 is adjusted.

The method may comprise, based on that the source audio 510 is determined to be outputted via the first speaker 351, turning off the second amplifier IC 320, adjusting the output level of the source audio 510 based on the sensing value 520 identified via the IV sensing circuitry 345, transferring the source audio 530 in which the output level is adjusted to the first amplifier IC 340 via the audio interface 460, and controlling the first amplifier IC 340 for the first amplifier IC to output the first audio signal 545 corresponding to the source audio 530 in which the output level is adjusted via the first speaker 351.

The method may comprise, based on that the source audio 510 is determined to be outputted via the second speaker 331, turning off the first amplifier IC 340, transferring the second audio signal 531 based on the source audio 510 in which the output level is not adjusted to the second amplifier IC 320, and controlling the second amplifier IC 320 for the second amplifier IC 320 to output the second audio signal 561 corresponding to the source audio 510 in which the output level is not adjusted, via the second speaker 331.

The method may comprise adjusting a playback time of the another portion 531 of the source audio 530 based on time required to adjust the output level of the portion 535 of the source audio 530, such that the second audio signal 561 and the first audio signal 545 are synchronized each other.

The audio interface 460 may include a first audio interface 460 for electrically connecting the first amplifier IC 340 and the processing circuitry 120, and a second audio interface 465 for electrically connecting the second amplifier IC 320 and the processing circuitry 120. The method may comprise transferring the portion 535 in which the output level of the source audio 530 is adjusted to the first amplifier IC 340 via the first audio interface 460. The method may comprise transferring the another portion 531 of the source audio 530 to the second amplifier IC 320 via the second audio interface 465.

The method may comprise adjusting an output level of an audio interval 583 having an output level exceeding a threshold level 571 or 575 among a plurality of audio intervals 581 and 583 of the portion 515, based on the sensing value 520.

As described above, a non-transitory computer readable storage medium may comprise one or more programs including instructions. The instructions may be configured to, when executed by the processing circuitry 120 individually or collectively, cause the electronic device 101 comprising a first amplifier IC 340 including IV (current and voltage) sensing circuitry 345 identifying voltage and/or a current of a first audio signal 545 outputted through the first amplifier integrated circuitry (IC) 340, a first speaker 351, connected to the first amplifier IC 340, converting the first audio signal 515 into sound, a second amplifier IC 320 outputting a second audio signal 511, a second speaker 331, connected to the second amplifier IC 320, converting the second audio signal 511 into sound, and processing circuitry 120, including an audio interface 460 electrically connected to the first amplifier IC 340 and the second amplifier IC 320, generating an audio signal to be inputted to the first amplifier IC 340 and the second amplifier IC 320 via the audio interface 460, to identify source audio 510. The instructions may be configured to, when executed by the processing circuitry 120 individually or collectively, cause the electronic device 101 to determine a speaker to which the source audio 510 is to be outputted. The instructions may be configured to, when executed by the processing circuitry 120 individually or collectively, cause the electronic device 101 to, based on that the source audio 510 is determined to be outputted via the first speaker 351 and the second speaker 331, based on sensing value 520 identified via the IV sensing circuitry 345, adjust an output level of a portion 525 of the source audio 510. The instructions may be configured to, when executed by the processing circuitry 120 individually or collectively, cause the electronic device 101 to, based on that the source audio 510 is determined to be outputted via the first speaker 351 and the second speaker 331, transfer the source audio 530 in which the output level of the portion 525 is adjusted, to the first amplifier IC 340 and the second amplifier IC 320 via the audio interface 460. The instructions may be configured to, when executed by the processing circuitry 120 individually or collectively, cause the electronic device 101 to, based on that the source audio 510 is determined to be outputted via the first speaker 351 and the second speaker 331, control the first amplifier IC 340, such that the first amplifier IC 340 outputs the first audio signal 545 corresponding to the portion 535 in which the output level of the source audio 530 is adjusted, via the first speaker 251. The instructions may be configured to, when executed by the processing circuitry 120 individually or collectively, cause the electronic device 101 to, based on that the source audio 510 is determined to be outputted via the first speaker 351 and the second speaker 331, control the second amplifier IC 320, such that the second amplifier IC 320 outputs the second audio signal 561 corresponding to another portion 531 in which the output level of the source audio 510 is not adjusted, via the second speaker 331.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a first audio output integrated circuit, IC, (340) including IV, current and voltage, sensing circuitry (345),
a first speaker (351) connected to the first audio output IC (340),
a second audio output IC (320),
a second speaker (331) connected to the second audio output IC (320),
processing circuitry (120) including an audio interface (460) connected to each of the first audio output IC (340) and the second audio output IC (320), and
memory 130, comprising one or more storage mediums, storing instructions, and
wherein the instructions that, when executed by the processing circuitry (120) individually or collectively, cause the electronic device to:
obtain, from the first audio output IC (340) via the audio interface (460), sensing data (520) identified by the IV sensing circuitry in the first audio output IC (340), in relation to output of an audio via the first speaker,
adjust a first audio signal (515) on a first channel, based on applying the sensing data (520) to source audio (510), and
provide, to each of the first audio output IC (340) and the second audio output IC (320) via the audio interface (460), an audio signal (530) including the adjusted first audio signal (515) on the first channel and a second audio signal (511) on a second channel, and
wherein applying the sensing data (520) to the source audio (510) comprises applying the sensing data (520) to the first audio signal (515) on the first channel among the first audio signal (515) on the first channel and a second audio signal (511) on the second channel included in the source audio (510).

2. The electronic device of claim 1,
wherein the audio interface (460) includes a single terminal (461) electrically connected to the first audio output IC (340) and the second audio output IC (320),
wherein the instructions that, when executed by the processing circuitry (120) individually or collectively, cause the electronic device (101) to:
provide, to each of the first audio output IC (340) and the second audio output IC (320) at the same time via the single terminal (461), the audio signal (530).

3. The electronic device of claim 1,
wherein the second audio output IC (320) includes:
another IV sensing circuitry (810) for obtaining another sensing data (520), and
a digital signal processor (DSP) (820) for adjusting the second audio signal (511) on the second channel, based on applying, to the second audio signal (511) on the second channel, the another sensing data identified by the another IV sensing circuitry (810) in the second audio output IC (320), in relation to output of an audio via the second speaker (331).

4. The electronic device of claim 1,
wherein the instructions that, when executed by the processing circuitry (120) individually or collectively, cause the electronic device (101) to:
control the first audio output IC (340) to identify, from the audio signal (530), the adjusted first audio signal (515) on the first channel for a first audio to be outputted via the first speaker (351), and
control the second audio output IC (320) to identify, from the audio signal (530), the second audio signal (511) on the second channel for a second audio to be outputted via the second speaker (331).

5. The electronic device of claim 1,
wherein the instructions that, when executed by the processing circuitry (120) individually or collectively, cause the electronic device (101) to:
based on that the source audio (510) is determined to be outputted via the first speaker (351) among the first speaker (351) and the second speaker (331):
turn off the second audio output IC (320),
adjust the first audio signal (515) on the first channel, based on the sensing data (520), and
provide, to the first audio output IC (340) via the audio interface (460), the audio signal including only the adjusted first audio signal (515) on the first channel.

6. The electronic device of claim 5,
wherein the instructions that, when executed by the processing circuitry (120) individually or collectively, cause the electronic device (101) to:
control the first audio output IC (340) to mix in mono, from the audio signal, the adjusted first audio signal (515) on the first channel for a first audio to be outputted via the first speaker (351).

7. The electronic device of claim 1,
wherein the instructions that, when executed by the processing circuitry (120) individually or collectively, cause the electronic device (101) to:
based on that the source audio (510) is determined to be outputted via the second speaker (331) among the first speaker (351) and the second speaker (331):
turn off the first audio output IC (340), and
provide, to the second audio output IC (320) via the audio interface (460), the audio signal including only the second audio signal (511) on the second channel.

8. The electronic device of claim 1,
wherein the source audio (510) is a stereo audio signal including the first audio signal (515) on a first frequency range and the second audio signal (511) on a second frequency range not overlapping the first frequency range.

9. The electronic device of claim 1,
wherein the instructions that, when executed by the processing circuitry (120) individually or collectively, cause the electronic device (101) to:
adjust a playback time of the second audio signal (511) of the source audio (510) based on time required to adjust the first audio signal (515) of the source audio (510), such that the second audio signal (511) and the first audio signal (515) are synchronized each other.

10. The electronic device of claim 1,
wherein the audio interface (460) includes:
a playback terminal electrically connected to an input terminal of the first audio output IC (340) and an input terminal of the second audio output IC (320), and
a capture terminal (463) electrically connected to an output terminal (473) of the first audio output IC (340) among the first audio output IC (340) and the second audio output IC (320), and for receiving the sensing data (520) of the IV sensing circuitry (345).

11. The electronic device of claim 1,
wherein the audio interface (460) includes:
a first audio interface (460) for electrically connecting the first audio output IC (340) and the processing circuitry (120), and
a second audio interface (465) for electrically connecting the second audio output IC (320) and the processing circuitry (120).

12. The electronic device of claim 11,
wherein the instructions that, when executed by the processing circuitry (120) individually or collectively, cause the electronic device (101) to:
provide, to the first audio output IC (340) via the first audio interface (460), the adjusted first audio signal (515) of the audio signal (530), and
provide, to the second audio output IC (320) via the second audio interface (465), the second audio signal (511) of the audio signal (530).

13. The electronic device of claim 1,
wherein the instructions that, when executed by the processing circuitry (120) individually or collectively, cause the electronic device (101) to:
adjust signal intensity of an audio interval (583) having signal intensity exceeding threshold signal intensity (571, 575) among a plurality of audio intervals (581, 583) of the first audio signal (515), based on the sensing data (520).

14. A method of an electronic device (101) comprising a first audio output integrated circuit (IC) (340) including IV (current and voltage) sensing circuitry (345), a first speaker (351) connected to the first audio output IC (340), a second audio output IC (320), a second speaker (331) connected to the second audio output IC (320), and processing circuitry (120) including an audio interface (460) connected to each of the first audio output IC (340) and the second audio output IC (320), the method comprising:
obtaining, from the first audio output IC (340) via the audio interface (460), sensing data (520) identified by the IV sensing circuitry in the first audio output IC (340), in relation to output of an audio via the first speaker (351),
adjusting a first audio signal (515) on a first channel, based on applying the sensing data (520) to source audio (510), and
providing, to each of the first audio output IC (340) and the second audio output IC (320) via the audio interface (460), an audio signal (530) including the adjusted first audio signal (515) on the first channel and a second audio signal (511) on a second channel, and
wherein applying the sensing data (520) to the source audio (510) comprises applying the sensing data (520) to the first audio signal (515) on the first channel between the first audio signal (515) on the first channel and a second audio signal (511) on the second channel included in the source audio (510).

15. A non-transitory computer readable storage medium, comprising
one or more programs including instructions,
wherein the instructions are configured, when executed by processing circuitry (120) of an electronic device (101) comprising a first audio output integrated circuit (IC) (340) including IV (current and voltage) sensing circuitry (345), a first speaker (351) connected to the first audio output IC (340), a second audio output IC (320), a second speaker (331) connected to the second audio output IC (320), and the processing circuitry (120) including an audio interface (460) connected to each of the first audio output IC (340) and the second audio output IC (320), individually or collectively, to cause the electronic device to:
obtain, from the first audio output IC (340) via the audio interface (460), sensing data (520) identified by the IV sensing circuitry in the first audio output IC (340), in relation to output of an audio via the first speaker (351),
adjust a first audio signal (515) on a first channel, based on applying the sensing data (520) to source audio (510), and
provide, to each of the first audio output IC (340) and the second audio output IC (320) via the audio interface (460), an audio signal including the adjusted first audio signal (515) on the first channel and a second audio signal (511) on a second channel, and
wherein applying the sensing data (520) to the source audio (510) comprises applying the sensing data (520) to the first audio signal (515) on the first channel between the first audio signal (515) on the first channel and a second audio signal (511) on the second channel included in the source audio (510).
